# EUROPEAN PATENT SPECIFICATION

(11) **EP 2 315 753 B1**
(45) Date of publication and mention of the grant of the patent: **07.10.2015**
(21) Application number: 09810177.7
(22) Date of filing: 25.08.2009
(51) Int. Cl.: C07D 239/26, C07D 403/10, H01L 51/54, H01L 51/50

(54) **MATERIAL FOR ORGANIC PHOTOELECTRIC DEVICE AND ORGANIC PHOTOELECTRIC DEVICE INCLUDING THE SAME**
MATERIAL FÜR EINE ORGANISCHE PHOTOELEKTRISCHE VORRICHTUNG UND ORGANISCHE PHOTOELEKTRISCHE VORRICHTUNG DAMIT
MATÉRIAU POUR DISPOSITIF PHOTOÉLECTRIQUE ORGANIQUE ET DISPOSITIF PHOTOÉLECTRIQUE ORGANIQUE LE COMPORTANT

(30) Priority: 25.08.2008 KR 20080082905; 08.06.2009 KR 20090050580
(43) Date of publication of application: 04.05.2011
(73) Proprietor: CHEIL INDUSTRIES INC., Kumi-city Kyungsangbuk-do 730-030 (KR)
(72) Inventor: KIM, Nam-Soo, Uiwang-si Gyeonggi-do 437-711 (KR); KANG, Myeong-Soon, Uiwang-si Gyeonggi-do 437-711 (KR); JUNG, Ho-Kuk, Uiwang-si Gyeonggi-do 437-711 (KR); KANG, Eui-Su, Uiwang-si Gyeonggi-do 437-711 (KR); PARK, Young-Sung, Uiwang-si Gyeonggi-do 437-711 (KR); CHAE, Mi-Young, Uiwang-si Gyeonggi-do 437-711 (KR); PARK, Jin-Seong, Uiwang-si Gyeonggi-do 437-711 (KR)
(74) Representative: Michalski Hüttermann & Partner Patentanwälte mbB
(86) International application number: PCT/KR2009/004730
(87) International publication number: WO 2010/024572

(56) References cited:
- EP-A1- 1 724 323
- EP-A2- 1 424 381
- WO-A1-2005/105950
- JP-A- 2004 031 004
- US-A1- 2004 086 745
- US-A1- 2004 110 031

## Description

### [Technical Field]

The present invention relates to a material for an organic photoelectric device and an organic photoelectric device including the same. More particularly, the present invention relates to a material for an organic photoelectric device that is capable of improving life-span, efficiency, driving voltage, electrochemical stability, and thermal stability, and an organic photoelectric device including the same.

### [Background Art]

An organic photoelectric device is a device requiring a charge exchange between an electrode and an organic material by using a hole or an electron.

An organic photoelectric device may be classified as follows in accordance with its driving principles. A first organic photoelectric device is an electron device driven as follows: excitons are generated in an organic material layer by photons from an external light source; the excitons are separated to electrons and holes; and the electrons and holes are transferred to different electrodes from each other as a current source (voltage source).

JP 2004 031004 A refers to an organic EL element attaining both improvement in luminous brightness as well as luminous efficiency and durability, and a display device using the organic EL element of a high luminous brightness and excellent durability.

EP 1 724 323 A1 refers to a material for an organic electroluminescence (EL) device having high luminous efficiency, high thermo stability, and a long lifetime, and an organic EL device utilizing the same. The material for an organic EL device is composed of a compound of a specified structure having a nitrogenous ring. The organic EL device has an organic thin film layer composed of one or more layers including at least a light emitting layer, the organic thin film layer being interposed between a cathode and an anode. In the organic EL device, at least one layer of the organic thin film layer contains the material for an organic EL device.

A second organic photoelectric device is an electron device driven as follows: a voltage or a current is applied to at least two electrodes to inject holes and/or electrons into an organic material semiconductor positioned at an interface of the electrodes; and then the device is driven by the injected electrons and holes.

As examples, the organic photoelectric device includes an organic light emitting diode (OLED), an organic solar cell, an organic photo-conductor drum, an organic transistor, an organic memory device, etc., and it requires a hole injecting or transporting material, an electron injecting or transporting material, or a light emitting material.

Although the organic light emitting diode is mainly described in the following description, the hole injecting or transporting material, the electron injecting or transporting material, and the light emitting material react in similar principles in the organic photoelectric devices.

An organic light emitting diode (OLED) has recently drawn attention due to an increase in demand for flat panel displays. In general, organic light emission refers to transformation of electrical energy to photo-energy.

The organic light emitting diode transforms electrical energy into light by applying current to an organic light emitting material. It has a structure in which a functional organic material layer is interposed between an anode and a cathode. The organic material layer includes multi-layer including different materials from each other, for example a hole injection layer (HIL), a hole transport layer (HTL), an emission layer, an electron transport layer (ETL), and an electron injection layer (EIL), in order to improve efficiency and stability of an organic light emitting diode.

In such an organic light emitting diode, when a voltage is applied between an anode and a cathode, holes from the anode and electrons from the cathode are injected to an organic material layer. The generated excitons generate light having certain wavelengths while shifting to a ground state.

In 1987, Eastman Kodak, Inc. firstly developed an organic light emitting diode including a low molecular aromatic diamine and aluminum complex as an emission-layer-forming material (Applied Physics Letters. 51, 913, 1987). C.W Tang et al. firstly disclosed a practicable device as an organic light emitting diode in 1987 (Applied Physics Letters, 51 12, 913-915, 1987). According to the reference, the organic layer has a structure in which a thin film (hole transport layer (HTL)) of a diamine derivative and a thin film of tris(8-hydroxy-quinolate)aluminum (Alq₃) are stacked.

Recently, it is has become known that a phosphorescent light emitting material can be used for a light emitting material of an organic light emitting diode in addition to the fluorescent light emitting material (D. F. O'Brien et al., Applied Physics Letters, 74 3, 442-444, 1999; M. A. Baldo et al., Applied Physics letters, 75 1, 4-6, 1999). Such a phosphorescent material emits lights by transiting the electrons from a ground state to an exited state, non-radiance transiting of a singlet exciton to a triplet exciton through intersystem crossing, and transiting a triplet exciton to a ground state to emit light.

As described above, in an organic light emitting diode, an organic material layer includes a light emitting material and a charge transport material, for example a hole injection material, a hole transport material, an electron transport material, an electron injection material, and so on.

The light emitting material is classified as blue, green, and red light emitting materials according to emitted colors, and yellow and orange light emitting materials to emit colors approaching natural colors.

When one material is used as a light emitting material, a maximum light emitting wavelength is shifted to a long wavelength or color purity decreases because of interactions between molecules, or device efficiency decreases because of a light emitting quenching effect. Therefore, a host/dopant system is included as a light emitting material in order to improve color purity and increase luminous efficiency and stability through energy transfer.

In order to implement the above excellent performance of an organic light emitting diode, a material constituting an organic material layer, for example a hole injection material, a hole transport material, a light emitting material, an electron transport material, an electron injection material, and a light emitting material such as a host and/or a dopant should be stable and have good efficiency. However, development of an organic material layer forming material for an organic light emitting diode has not been satisfactory up to now and thus there is a need for a novel material. This material development is also required for other organic photoelectric devices.

### [Disclosure]

### [Technical Problem]

An exemplary embodiment of the present invention provides a novel material that can act as a hole injection, hole transport, light emitting, or electron injection and/or transport material, and also as a light emitting host along with an appropriate dopant.

Another embodiment of the present invention provides an organic photoelectric device including the material for an organic photoelectric device, and having improved life-span, efficiency, driving voltage, electrochemical stability, and thermal stability.

The embodiments of the present invention are not limited to the above technical purposes, and a person of ordinary skill in the art can understand other technical purposes.

### [Technical Solution]

According to one embodiment of the present invention, a material for an organic photoelectric device including an asymmetric compound represented by the following Chemical Formula 1 is provided: 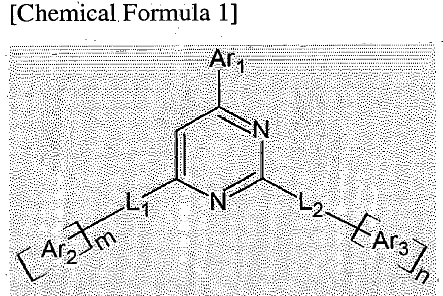 wherein, in the above Chemical Formula 1,
- Ar₁: is selected from the group consisting of hydrogen, an unsubstituted phenyl, an unsubstituted naphthyl, an unsubstituted anthracenyl, an unsubstituted phenanthrenyl, an unsubstituted pyrenyl, an unsubstituted perylenyl, and an unsubstituted chrysenyl,
- Ar₂ and Ar₃: are independently selected from the group consisting of a substituted or unsubstituted carbazolyl, a substituted or unsubstituted C2 to C30 heteroaryl, a substituted or unsubstituted C2 to C30 arylamine, and a substituted or unsubstituted C2 to C30 heteroarylamine,
- L₁ and L₂: are independently selected from the group consisting of a substituted or unsubstituted phenylene, a substituted or unsubstituted naphthylene, and a substituted or unsubstituted anthracene, and
- m and n: are integers ranging from 1 to 4.

According to another embodiment of the present invention, an organic photoelectric device is provided that includes an anode, a cathode, and an organic thin layer disposed between the anode and cathode. The organic thin layer includes the material for the organic photoelectric device. According to a further embodiment of the present invention, a display device including the organic photoelectric device is provided.

Hereinafter, further embodiments of the present invention will be described in detail.

The material for an organic photoelectric device according to one embodiment has an asymmetric structure with respect to a pyrimidine core. Such asymmetric structure including a pyrimidine core reinforces amorphous characteristics and thereby suppresses crystallization, improving life-span characteristics of an organic photoelectric device when an organic photoelectric device is driven. Therefore, an organic photoelectric device having excellent efficiency, driving voltage, electrochemical stability, and thermal stability is provided.

### [Advantageous Effects]

The novel material according to one embodiment of the present invention can act as a hole injection, hole transport, light emitting, or electron injection and/or transport material, and also as a light emitting host along with an appropriate dopant in an organic photoelectric device such as an organic light emitting diode.

### [Description of Drawings]

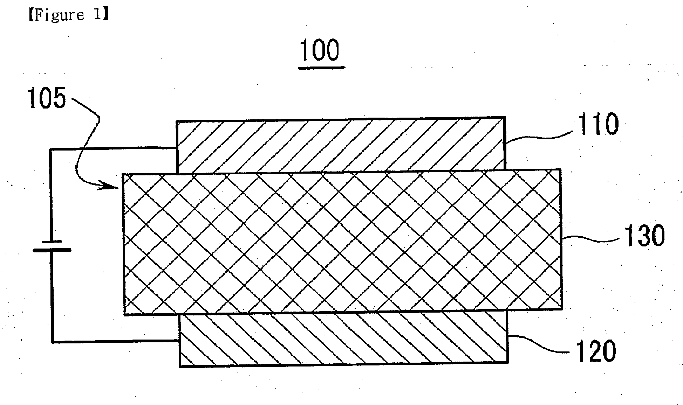

FIGS. 1 to 5 are cross-sectional views showing organic light emitting diodes including compounds according to various embodiments of the present invention.

### <Description of Reference Numerals Indicating Primary Elements in the Drawings>

| | | | |
|---|---|---|---|
| 100: | organic photoelectric device | 110: | cathode |
| 120: | anode | 105: | organic thin layer |
| 130: | emission layer | 140: | hole transport layer (HTL) |
| 150: | electron transport layer (ETL) | 160: | electron injection layer (EIL) |
| 170: | hole injection layer (HIL) | | |
| 230: | emission layer + electron transport layer (ETL) | | |

### [Best Mode]

Exemplary embodiments of the present invention will hereinafter be described in detail. However, these embodiments are only exemplary, and the present invention is not limited thereto. As used herein, when specific definition is not provided, the term "substituted" refers to one substituted with at least a substituent selected from the group consisting of a C1 to C30 alkyl, a C1 to C10 heteroalkyl, a C3 to C30 cycloalkyl, a C6 to C30 aryl, a C1 to C30 alkoxy, a fluoro, and a cyano.

As used herein, when specific definition is not provided, the term "hetero" refers to one including 1 to 3, including N, O, S, P, or Si, and remaining carbons in one ring.

According to one embodiment of the present invention, a material for an organic photoelectric device including an asymmetric compound represented by the following Chemical Formula 1 is provided: 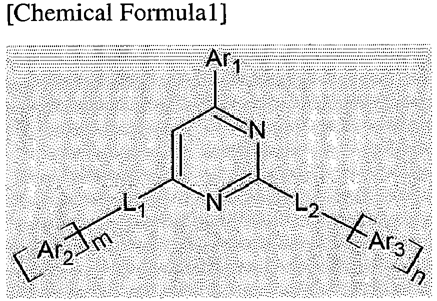 wherein, in the above Chemical Formula 1,
Ar₁ is selected from the group consisting of hydrogen and an unsubstituted aryl, Ar₂ and Ar₃ are independently selected from the group consisting of a substituted or unsubstituted carbazolyl, a substituted or unsubstituted C2 to C30 heteroaryl, a substituted or unsubstituted C2 to C30 arylamine, and a substituted or unsubstituted C2 to C30 heteroarylamine, L₁ and L₂ are independently selected from the group consisting of a substituted or unsubstituted phenylene, a substituted or unsubstituted naphthylene, and a substituted or unsubstituted anthracene, and
m and n are integers ranging from 1 to 4.

In the above Chemical Formula 1, Ar₁ is an unsubstituted aryl. Examples of the aryl are phenyl, naphthyl, anthracenyl, phenanthrenyl, pyrenyl, perylenyl, chrysenyl, and the like.

The material for an organic photoelectric device having such an asymmetric structure suppresses crystallization, and thus improves life-span characteristics of an organic photoelectric device.

In the above Chemical Formula 1, the heteroaryl represented by Ar₂ and Ar₃ includes imidazolyl, thiazolyl, oxazolyl, oxadiazolyl, triazolyl, pyridinyl, pyridazine, quinolinyl, isoquinolinyl, acridyl, imidazopyridinyl, imidazopyrimidinyl, and the like.

In the above Chemical Formula 1, the heteroarylamine represented by Ar₂ and Ar₃ includes diphenyl amine, dinaphthyl amine, dibiphenyl amine, phenyl naphthyl amine, phenyl diphenyl amine, ditolyl amine, phenyl tolyl amine, carbazoyl, triphenylamine, dipyridyl amine, and the like.

Each substituent represented by Ar₂ and Ar₃ in the above Chemical Formula 1 may be substituted or unsubstituted. When Ar₂ and Ar₃ are substituted, they may be substituted with one selected from the group consisting of a C1 to C30 alkyl, a C1 to C10 heteroalkyl, a C3 to C30 cycloalkyl, a C6 to C30 aryl, a C1 to C30 alkoxy, a fluoro, and a cyano. Examples of the aryl include one selected from the group consisting of phenyl, naphthyl, anthracenyl, phenanthrenyl, pyrenyl, perylenyl, and chrysenyl. Examples of the heteroalkyl include alkylsilyl. However, the aryl and heteroalkyl are not limited to the above described.

In the above Chemical Formula 1, L₁ and L₂ are preferably phenylene.

The compound of the above Chemical Formula 1 according to the present invention includes a pyrimidine core and substituents of Ar₁ to Ar₃. Pyrimidine is an aromatic compound and has an electron structure such as benzene. The pyrimidine has thermal stability or relatively high resistance to oxidation, but it can synthesize an asymmetric compound by the reactivity difference with respect to 2-, 4-, and 6- positions.

According to one embodiment, the pyrimidine core is substituted with substituents that are not identical to each other, and forms an asymmetric structure. The amorphous characteristic can be enhanced in the pyrimidine core structure having an asymmetric substituent, and the crystallization is suppressed to improve the life-span characteristic while driving the organic photoelectric device. On the other hand, the symmetric compound having the same substituents is easily crystallized, so it may cause shortening of the life-span characteristic of an organic light emitting diode.

The various substituents (Ar₁ to Ar₃) are introduced to the pyrimidine having the above-mentioned characteristic to provide the organic photoelectric device with the required characteristics.

For example, it is possible to synthesize a thermally electrically stable n-type material by introducing a substituent having a p-type property such as a pyridinyl group, a quinolinyl group, and an isoquinolinyl group to Ar₂ and Ar₃, and it is possible to synthesize a p-type material by introducing substituents having the p-type property.It is also possible to provide an amphiphilic material having both n-type and p-type properties by introducing both an n-type substituent and a p-type substituent.

The n-type property means a property of a conductive characteristic depending upon the LUMO level, so as to have an anionic characteristic due to the electron formation. The p-type property means a property of a conductive characteristic depending upon the HOMO level, so as to have a cationic characteristic due to the hole formation.

The compound represented by Chemical Formula 1 is introduced with the various substituents, so the total molecular property thereof may be further enriched into an n-type or a p-type. In other words, when a certain substituent is introduced to the substituting part in Chemical Formula 1 to enrich the property of a chemical represented by Chemical Formula 1 to either one, the compound represented by Chemical Formula 1 can become a compound that further satisfies the conditions for the material for hole injection, hole transport, light emitting, electron injection, or electron transport.

For example, when Ar₂ and Ar₃ is substituted with a heteroarylamine group, the compound represented by Chemical Formula 1 has wider application fields such as a material for a hole injection layer (HIL) and a hole transport layer (HTL).

On the other hand, when Ar₂ and Ar₃ are substituted with materials having an excellent electron affinity such as a hetero aryl group, the compound represented by Chemical Formula 1 may be applied to a material for an electron injection layer or an electron transport layer (ETL).

As described above, it is possible to synthesize a compound having the various energy band gaps by introducing the various substituents in the Ar₁ to Ar₃ position in Chemical Formula 1. Thereby, the compound represented by Chemical Formula 1 may become a compound satisfying the condition required for a hole injection layer (HIL), a hole transport layer (HTL), an emission layer, an electron injection layer, and a transport layer.

It is possible to accomplish a device having a low driving voltage and high photo efficiency by selecting a compound having a suitable energy level depending upon the substituent of Compound 1 and applying it to an organic electronic device.

Specific examples of the compound represented by the above Chemical Formula 1 include the following compounds (1) to (90) or combinations thereof, but are not limited thereto.

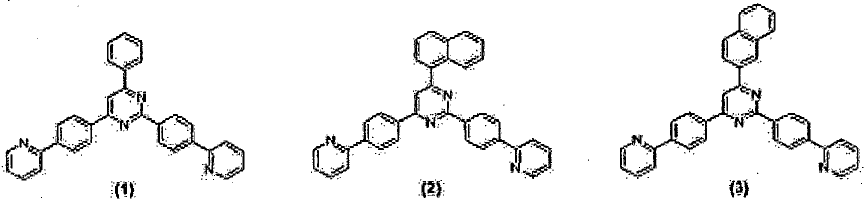

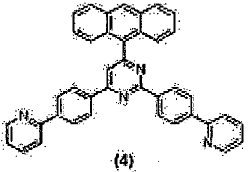

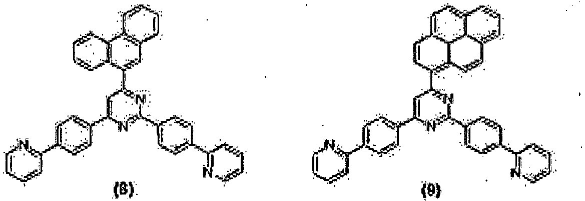

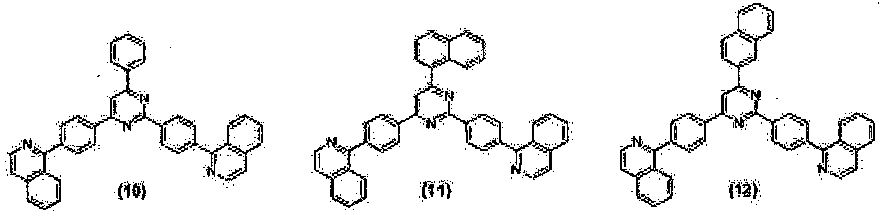

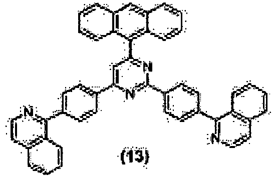

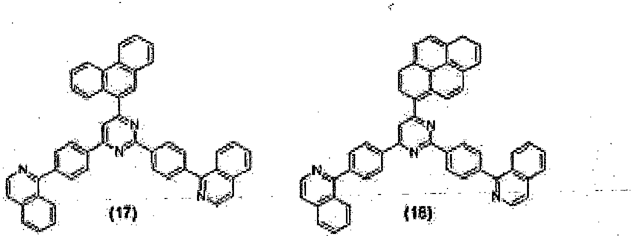

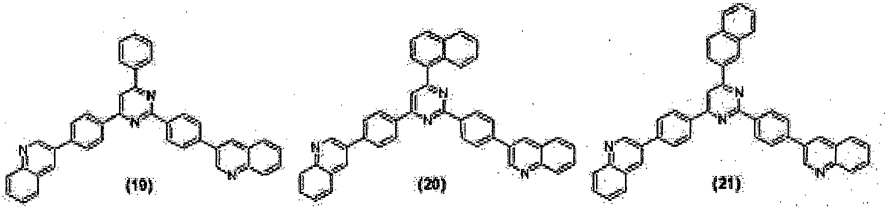

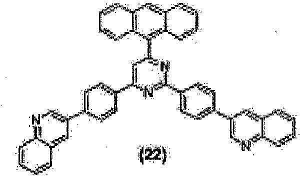

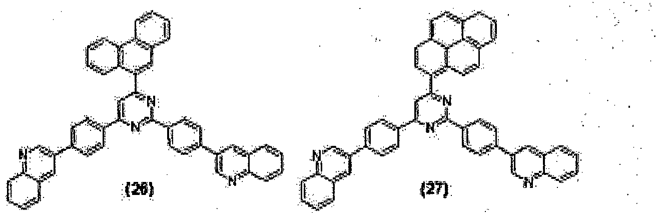

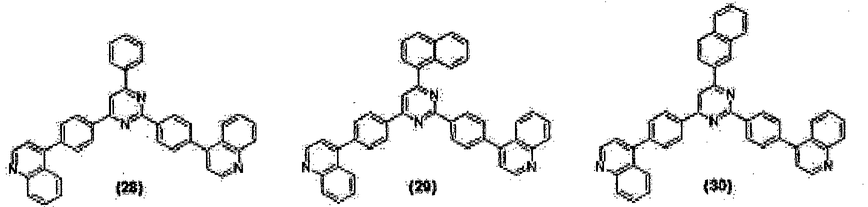

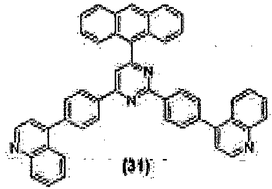

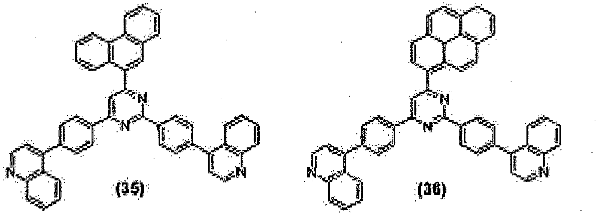

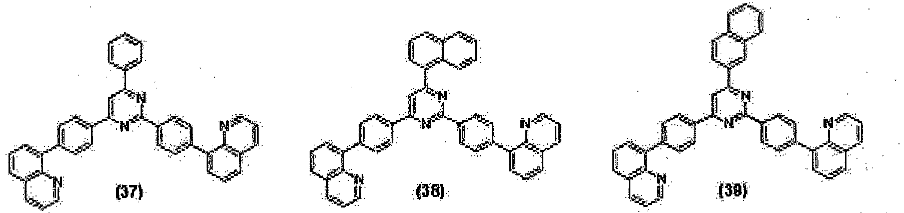

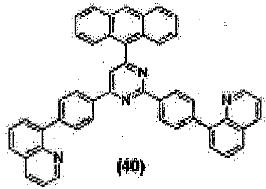

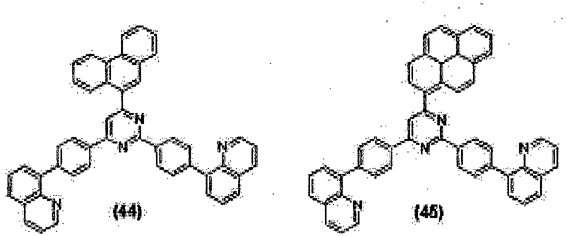

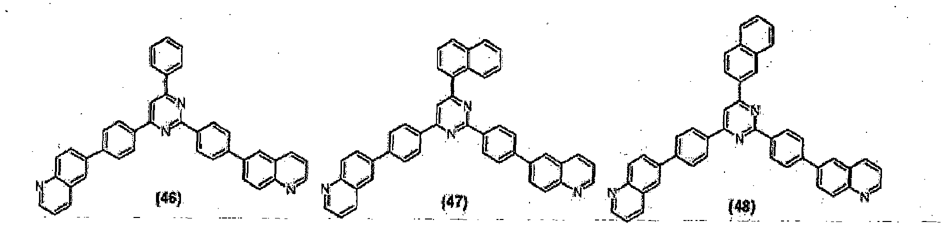

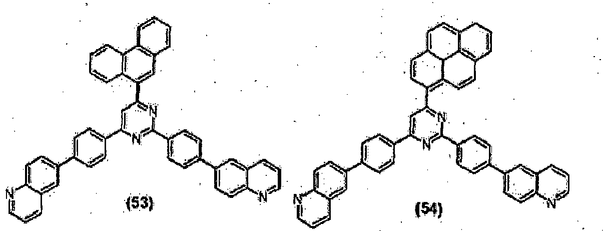

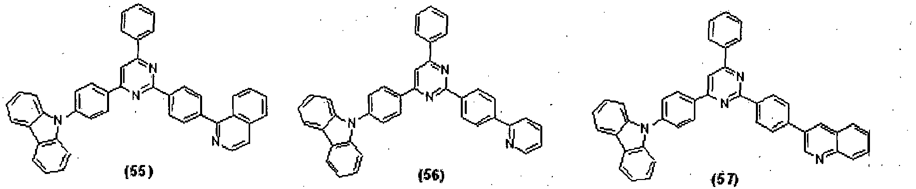

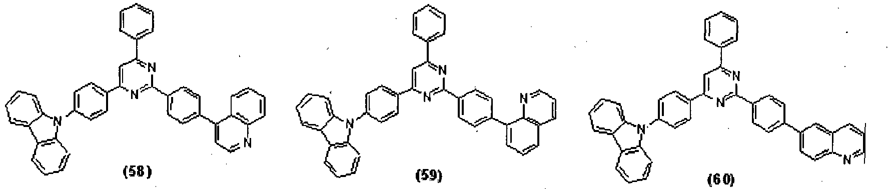

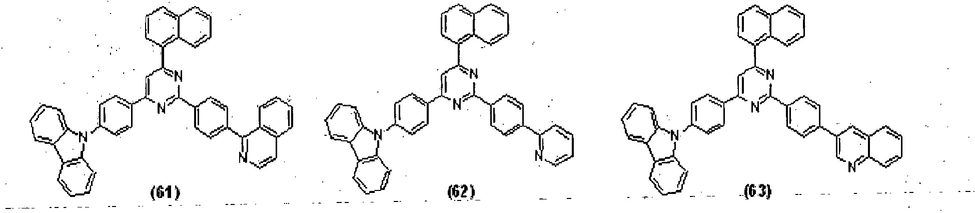

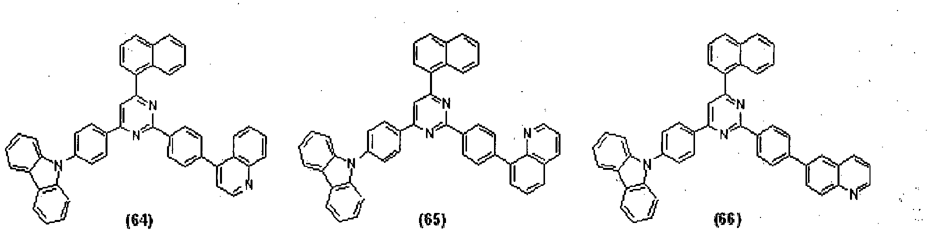

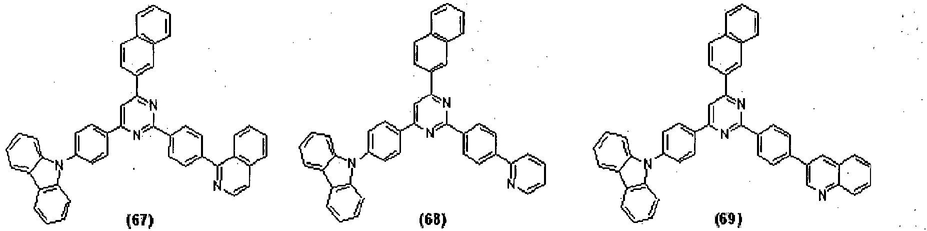

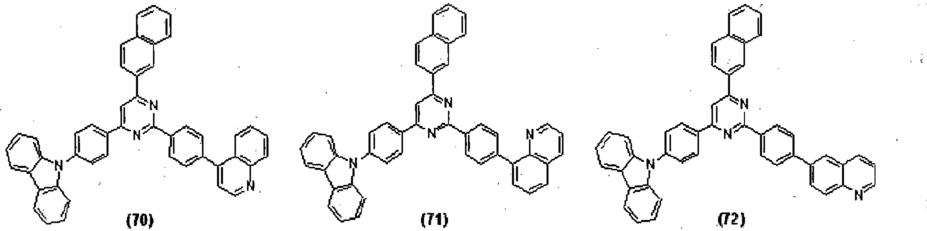

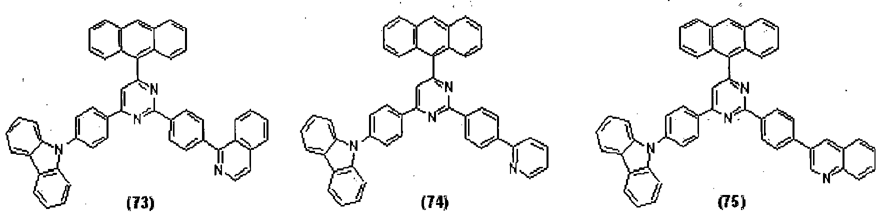

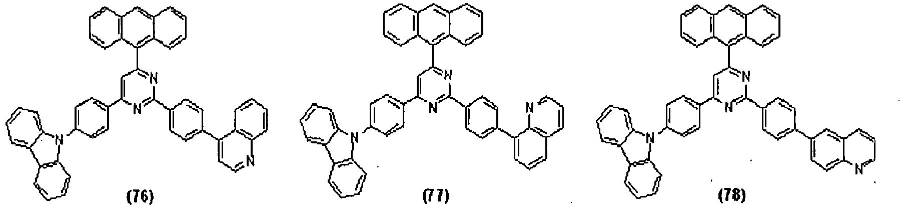

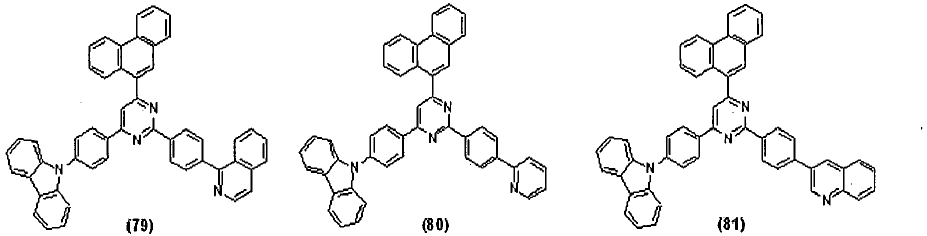

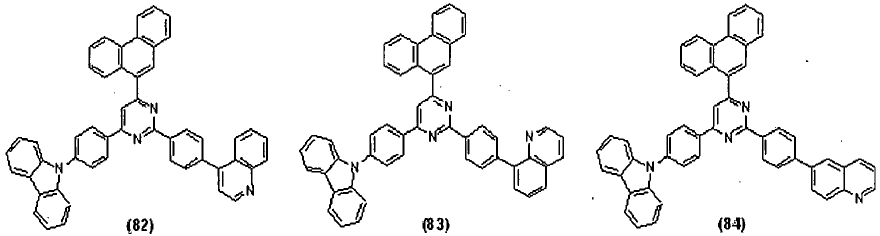

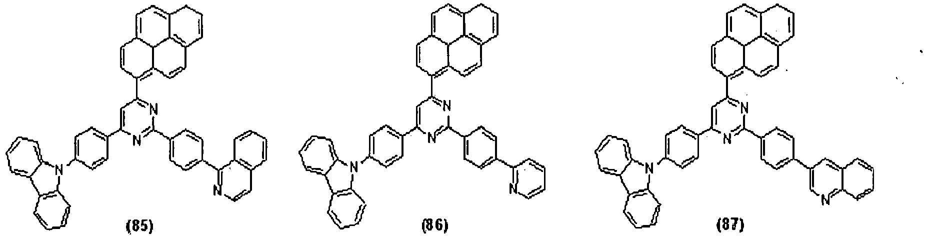

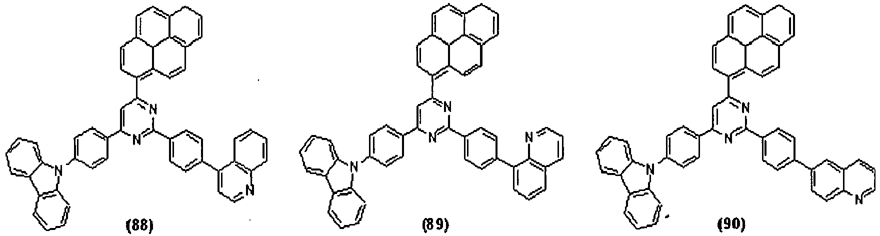

The material for an organic photoelectric device including the above compounds can play a role of hole injection, hole transport, light emitting, or electron injection and/or transport, and also as a light emitting host with an appropriate dopant. According to the embodiment of the present invention, a compound for an organic photoelectric device can improve life-span and electrochemical and thermal stability, and decrease the driving voltage for improving the life-span and efficiency characteristics of an organic photoelectric device when included in an organic thin layer.

According to another embodiment of the present invention, an organic photoelectric device including the material for the organic photoelectric device is provided. The organic photoelectric device includes an organic light emitting diode, an organic solar cell, an organic transistor, an organic photo-conductor drum, an organic memory device, and the like.

As for an organic solar cell, the new compound of the present invention is included in an electrode or an electrode buffer layer and can thereby improve quantum efficiency. As for an organic transistor, it can be used as an electrode material in a gate, a source-drain electrode, and the like.

Hereinafter, an organic light emitting diode is illustrated in more detail. According to another embodiment of the present invention, an organic light emitting diode including an anode, a cathode, and at least one organic thin layer disposed between the anode and cathode is provided. The organic thin layer includes the material for an organic photoelectric device.

The organic thin layer is selected from the group consisting of an emission layer; and a hole transport layer (HTL), a hole injection layer (HIL), an electron transport layer (ETL), an electron injection layer (EIL), a hole blocking layer, and combinations thereof. At least one layer includes a material for an organic photoelectric device according to the present invention.

FIGS. 1 to 5 are cross-sectional views showing an organic light emitting diode including the material for an organic photoelectric device according to one embodiment of the present invention.

Referring to FIGS. 1 to 5, organic light emitting diodes 100, 200, 300, 400, and 500 according to embodiments includes at least one organic thin layer 105 interposed between an anode 120 and a cathode 110.

The anode 120 includes an anode material laving a large work function to help hole injection into an organic thin layer. The anode material includes a metal such as nickel, platinum, vanadium, chromium, copper, zinc, and gold, or alloys thereof; a metal oxide such as zinc oxide, indium oxide, indium tin oxide (ITO), and indium zinc oxide (IZO); a combined metal and oxide such as ZnO:Al or SnO₂:Sb; or a conductive polymer such as poly(3-methylthiophene), poly[3,4-(ethylene-1,2-dioxy)thiophene] (PEDT), polypyrrole, and polyaniline, but is not limited thereto. It is preferable to include a transparent electrode including ITO (indium tin oxide) as an anode. The cathode 110 includes a cathode material having a small work function to help electron injection into an organic thin layer. The cathode material includes a metal such as magnesium, calcium, sodium, potassium, titanium, indium, yttrium, lithium, gadolinium, aluminum, silver, tin, and lead, or alloys thereof; or a multi-layered material such as LiF/Al, Liq/Al, LiO₂/Al, LiF/Ca, LiF/Al, and BaF₂/Ca, but is not limited thereto. It is preferable to include a metal electrode including aluminum as a cathode.

Referring to FIG. 1, the organic photoelectric device 100 includes an organic thin layer 105 including only an emission layer 130.

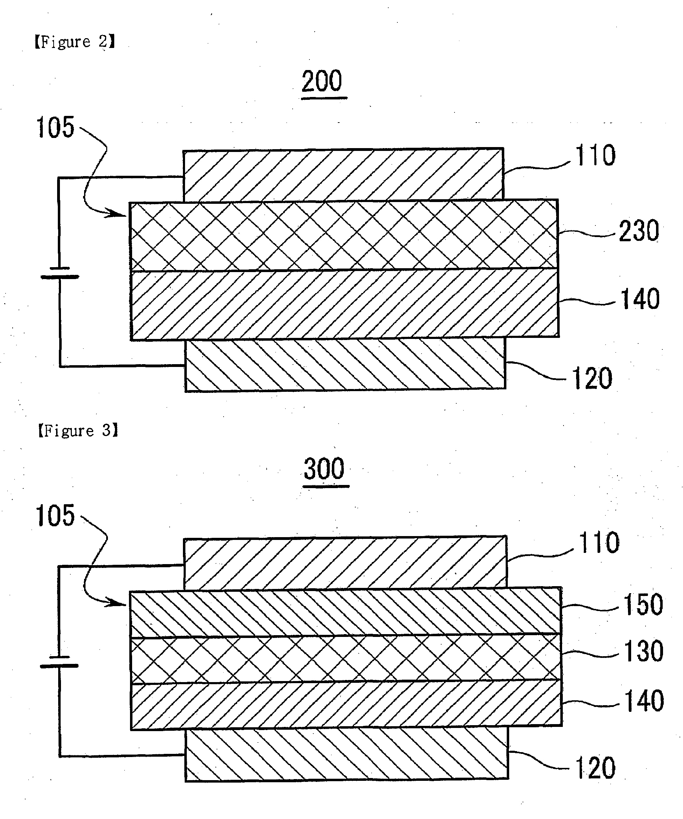

Referring to FIG. 2, a double-layered organic photoelectric device 200 includes an organic thin layer 105 including an emission layer 230 including an electron transport layer (ETL), and a hole transport layer (HTL) 140. The emission layer 130 also functions as an electron transport layer (ETL), and the hole transport layer (HTL) 140 layer has an excellent binding property with a transparent electrode such as ITO or an excellent hole transporting property.

Referring to FIG. 3, a three-layered organic photoelectric device 300 includes an organic thin layer 105 including an electron transport layer (ETL) 150, an emission layer 130, and a hole transport layer (HTL) 140. The emission layer 130 is independently installed, and layers having an excellent electron transporting property or an excellent hole transporting property are separately stacked.

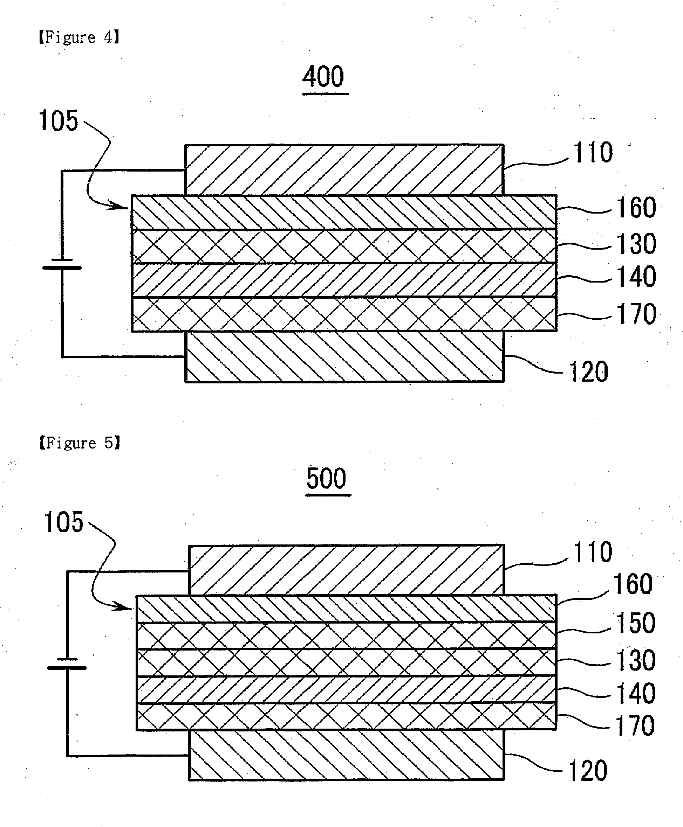

As shown in FIG. 4, a four-layered organic photoelectric device 400 includes an organic thin layer 105 including an electron injection layer (EIL) 160, an emission layer 130, a hole transport layer (HTL) 140, and a hole injection layer (HIL) 170 for binding with the cathode of INTO.

As shown in FIG. 5, a five layered organic photoelectric device 500 includes an organic thin layer 105 including an electron transport layer (ETL) 150, an emission layer 130, a hole transport layer (HTL) 140, and a hole injection layer (HIL) 170, and further includes an electron injection layer (EIL) 160 to achieve a low voltage.

In FIGS. 1 to 5, the organic thin layer 105 including at least one selected from the group consisting of an electron transport layer (ETL) 150, an electron injection layer (EIL) 160, an emission layer 130 and 230, a hole transport layer (HTL) 140, a hole injection layer (HIL) 170, and combinations thereof includes a material for an organic photoelectric device. The material for the organic photoelectric device may be used for an electron transport layer (ETL) 150 including the electron transport layer (ETL) 150 or electron injection layer (EIL) 160. When it is used for the electron transport layer (ETL), it is possible to provide an organic photoelectric device having a more simple structure because it does not require an additional hole blocking layer (not shown).

Furthermore, when the material for an organic photoelectric device is included in the emission layer 130 and 230, the material for the organic photoelectric device may be included as a phosphorescent or fluorescent host or a fluorescent blue dopant.

The organic light emitting diode may be fabricated by forming an anode on a substrate; forming an organic thin layer in accordance with a dry coating method such as an evaporation, a sputtering, a plasma plating, and an ion plating or a wet coating method such as spin coating, dipping, and flow coating; and providing a cathode thereon.

Another embodiment of the present invention provides a display device including the organic photoelectric device according to the above embodiment.

### [Mode for Invention]

The following examples illustrate the present invention in more detail. However, it is understood that the present invention is not limited by these examples.

### (Preparing Material for Organic Photoelectric Device)

### Synthesis Example 1: Synthesis of Compound (1)

For the specific example of the material for an organic photoelectric device, the compound (1) was synthesized in accordance with the following Reaction Scheme 1 in two steps.

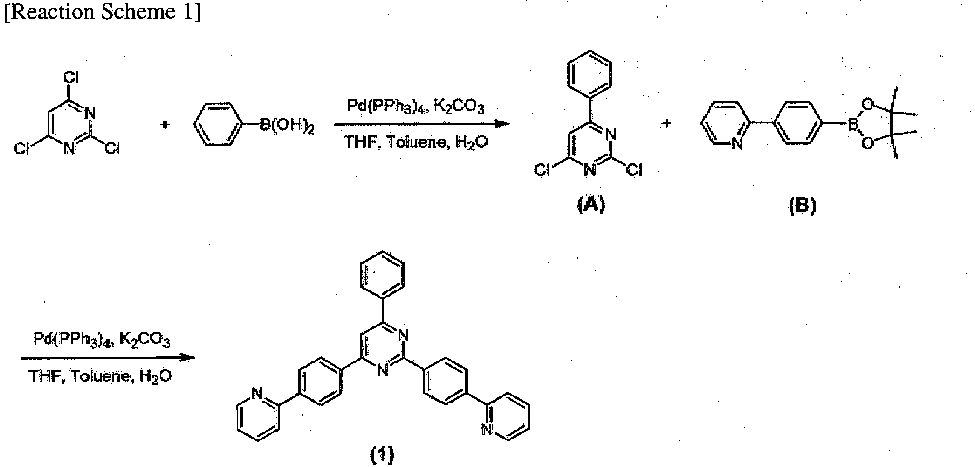

### First Step: Synthesizing Intermediate Product (A)

*11275.0 g (409 mmol) of 2,4,6-trichloropyrimidine, 54.8 g (450 mmol) of phenylboronic acid, and 11.8 g (10 mmol) of tetrakis-(triphenylphosphine)palladium were suspended in a mixed solvent of 450 ml of tetrahydrofuran and 300 ml of toluene to provide a suspension. The suspension was added to a solution in which 113.0 g (818 mmol) of potassium carbonate was dissolved in 300 ml of water, and the obtained mixture was heated and refluxed for 9 hours. After separating the reaction fluid into two layers, an organic layer was washed with a saturated sodium chloride aqueous solution and dried with anhydrous sodium sulfate.

The organic solvent was distillated and removed under reduced pressure, and then the residue was recrystallized with toluene. The obtained crystal was separated by filtration and washed with toluene to obtain 64.7 g (yield: 70.3 %) of intermediate product (A).

### Second Step: Synthesizing Compound (1)

2.3 g (10 mmol) of intermediate product (A), 6.3 g (22 mmol) of 2-(4-(4,4,5,5-tetramethyl-1,3,2-dioxaborolan-2-yl)phenyl)pyridine (B), and 0.6 g (0.5 mmol) of tetrakis-(triphenylphosphine)palladium were suspended in a mixed solvent of 70 ml of tetrahydrofuran and 50 ml of toluene to provide a suspension. The suspension was added to a solution in which 5.7 g (41 mmol) of potassium carbonate was dissolved in 50 ml of water. The obtained mixture was heated and refluxed for 12 hours. After separating the reaction fluid into two layers, an organic layer was washed with a saturated sodium chloride aqueous solution and dried with anhydrous sodium sulfate.

The organic solvent was distillated and removed under reduced pressure, and then the residue was recrystallized with toluene. The obtained crystal was separated by filtration and washed with toluene to obtain 3.9 g (yield: 67.9 %) of compound (1).

¹H NMR (300MHz, CDCl₃) 8.85 (d,2H), 8.75 (d,2H), 8.45 (d,2H), 8.34 (d,2H), 8.21 (m,4H), 8.08 (s,1H), 7.80 (m,4H), 7.60 (m,3H), 7.27 (m,2H); MS[M+1] 463.

### Synthesis Example 2: Synthesizing Compound (2)

For the specific example of the material for an organic photoelectric device, compound (2) was synthesized in accordance with the following Reaction Scheme 2 in two steps.

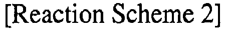

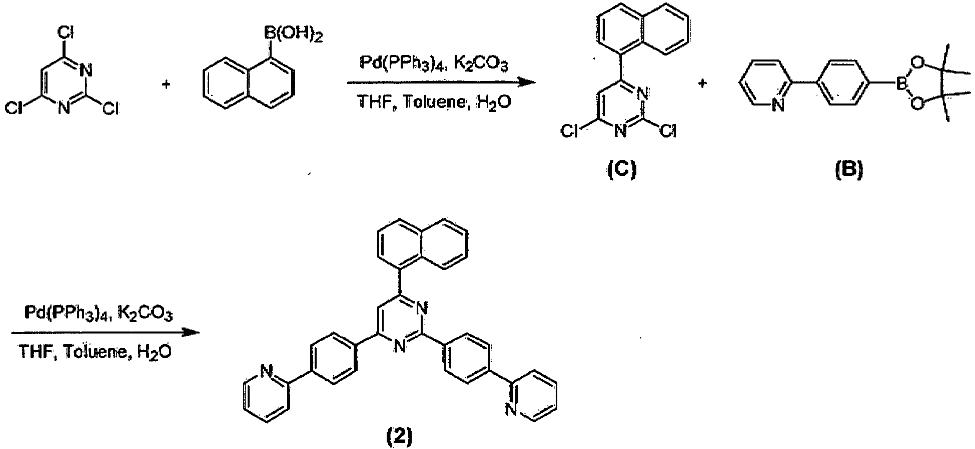

### First Step: Synthesizing Intermediate Product (C)

75.0 g (409 mmol) of 2,4,6-trichloropyrimidine, 77.3 g (450 mmol) of naphthylboronic acid, and 11.8 g (10 mmol) of tetrakis-(triphenylphosphine)palladium were suspended in a mixed solvent of 450 ml of tetrahydrofuran and 300 ml of toluene to provide a suspension. The suspension was added to a solution in which 113.0 g (818 mmol) of potassium carbonate was dissolved in 300 ml of water, and the obtained mixture was heated and refluxed for 9 hours. After separating the reaction fluid into two layers, an organic layer thereof was washed with a saturated sodium chloride aqueous solution and dried with anhydrous sodium sulfate.

The organic solvent was distillated and removed under reduced pressure, and then the residue was recrystallized with toluene. The obtained crystal was separated by filtration and washed with toluene to obtain 80.0 g (yield: 71.1 %) of intermediate product (C).

### Second Step: Synthesizing Compound (2)

3.2 g (12 mmol) of intermediate product (C), 7.2 g (26 mmol) of 2-(4= (4,4,5,5-tetramethyl-1,3,2-dioxaborolan-2-yl)phenyl)pyridine (B), and 0.7 g (0.6 mmol) of tetrakis-(triphenylphosphine)palladium were suspended in a mixed solvent of 100 ml of tetrahydrofuran and 65 ml of toluene to provide a suspension. The suspension was added to a solution in which 6.4 g (47 mmol) of potassium carbonate was dissolved in 65 ml of water. The obtained mixture was heated and refluxed for 12 hours. After separating the reaction fluid into two layers, an organic layer thereof was washed with a saturated sodium chloride aqueous solution and dried with anhydrous sodium sulfate.

The organic solvent was distillated and removed under reduced pressure, and then the residue was recrystallized with toluene. The extracted crystal was separated by filtration and washed with toluene to obtain 4.1 g (yield: 69.0 %) of compound (2).

¹H NMR (300MHz, CDCl₃) 8.85 (d,2H), 8.76 (d,2H), 8.45 (m,3H), 8.20 (m,4H), 8.01 (m,3H), 7.80 (m,5H), 7.61 (m,3H), 7.27 (m,2H); MS[M+1] 513.

### Synthesis Example 3: Synthesizing Compound (10)

For the specific example of the material for organic photoelectric device, the compound (10) was synthesized in accordance with the following Reaction Scheme 3.

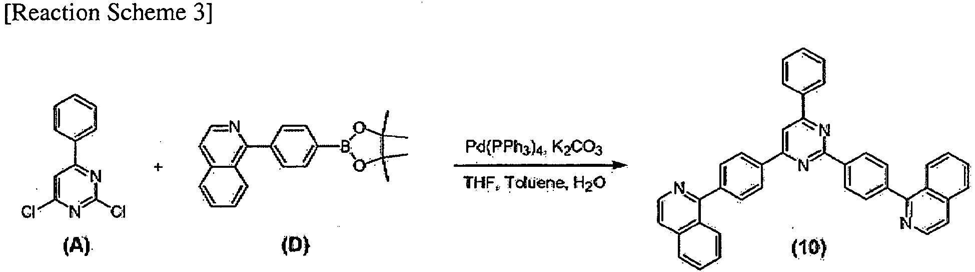

2.3 g (10 mmol) of intermediate product (A), 7.5 g (22 mmol) of 1-(4- (4,4,5,5-tetramethyl-1,3,2-dioxaborolan-2-yl)phenyl)isoquinoline (D), and 0.6 g (0.5 mmol) of tetrakis-(triphenylphosphine)palladium were suspended in a mixed solvent of 70 ml of tetrahydrofuran and 50 ml of toluene to provide a suspension. The suspension was added to a solution in which 5.7 g (41 mmol) of potassium carbonate was dissolved in 50 ml of water. The obtained mixture was heated and refluxed for 12 hours. After separating the reaction fluid into two layers, an organic layer thereof was washed with a saturated sodium chloride aqueous solution and dried with anhydrous sodium sulfate.

The organic solvent was distillated and removed under reduced pressure, and then the residue was recrystallized with toluene. The extracted crystal was separated by filtration and washed with toluene to obtain 3.9 g (yield: 68.0 %) of compound (10).

¹H NMR (300MHz, CDCl₃) 8.94 (d,2H), 8.68 (d,2H), 8.52 (d,2H), 8.39 (d,2H), 8.21 (d,2H), 8.16 (s,1H), 7.94 (m,6H), 7.72 (m,4H), 7.61 (m,5H); MS[M+1] 563.

### Synthesis Example 4: Synthesizing Compound (11)

For a specific example of the material for organic photoelectric device, the compound (11) was synthesized in accordance with the following Reaction Scheme 4.

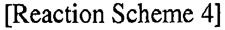

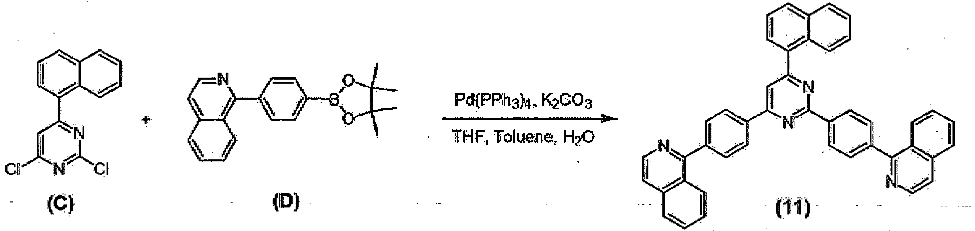

2.7 g (10 mmol) of intermediate product (C), 7.2 g (22 mmol) of 1-(4- (4,4,5,5-tetramethyl-1,3,2-dioxaborolan-2-yl)phenyl)isoquinoline (D), and 0.6 g (0.5 mmol) of tetrakis-(triphenylphosphine)palladium were suspended in a mixed solvent of 80 ml of tetrahydrofuran and 55 ml of toluene to provide a suspension. The suspension was added to a solution in which 5.4 g (391 mmol) of potassium carbonate was dissolved in 55 ml of water. The obtained mixture was heated and refluxed for 12 hours. After separating the reaction fluid into two layers, an organic layer thereof was washed with a saturated sodium chloride aqueous solution and dried with anhydrous sodium sulfate.

The organic solvent was distillated and removed under reduced pressure, and then the residue was recrystallized with toluene. The extracted crystal was separated by filtration and washed with toluene to obtain 4.5 g (yield: 65.0 %) of compound (11).

¹H NMR (300MHz, CDCl₃) 8.93 (d,2H), 8.67 (d,2H), 8.53 (d,2H), 8.45 (d,1H), 8.21 (d,2H), 7.96 (m,10H), 7.72 (m,5H), 7.64 (m,4H); MS[M+1] 613.

### Synthesis Example 5: Synthesizing Compound (19)

For a specific example of the material for organic photoelectric device, the compound (19) was synthesized in accordance with the following Reaction Scheme 5.

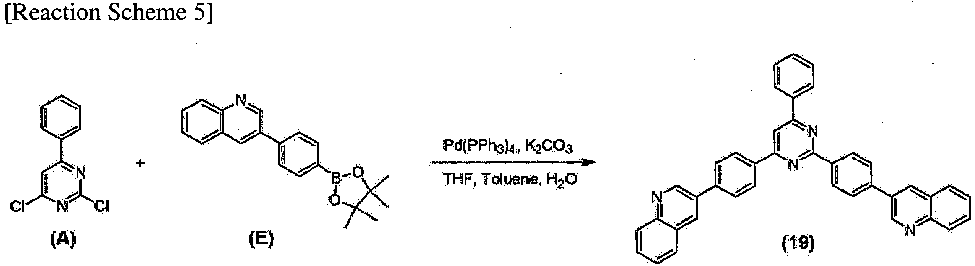

4.0 g (18 mmol) of intermediate product (A), 13.0 g (39 mmol) of 3-(4- (4,4,5,5-tetramethyl-1,3,2-dioxaborolan-2-yl)phenyl)quinoline (E), and 1.0 g (0.9 mmol) of tetrakis-(triphenylphosphine)palladium were suspended in a mixed solvent of 120 ml of tetrahydrofuran and 80 ml of toluene to provide a suspension. The suspension was added to a solution in which 9.8 g (71 mmol) of potassium carbonate was dissolved in 80 ml of water. The obtained mixture was heated and refluxed for 12 hours. After separating the reaction fluid into two layers, an organic layer thereof was washed with a sodium chloride saturated aqueous solution and dried with anhydrous sodium sulfate.

The organic solvent was distillated and removed under reduced pressure, and then the residue was recrystallized with toluene. The extracted crystal was separated by filtration and washed with toluene to obtain 6.5 g (yield: 64.7 %) of compound (19).

¹H NMR (300MHz, CDCl₃) 9.31 (d,2H), 8.89 (d,2H), 8.40 (m,6H), 8.17 (d,2H), 8.09 (s,1H), 7.92 (m,6H), 7.75 (m,2H), 7.59 (m,5H); MS[M+1] 563.

### Synthesis Example 6: Synthesizing Compound (63)

For the specific example of the material for an organic photoelectric device, the compound (63) was synthesized in accordance with the following Reaction Scheme 6.

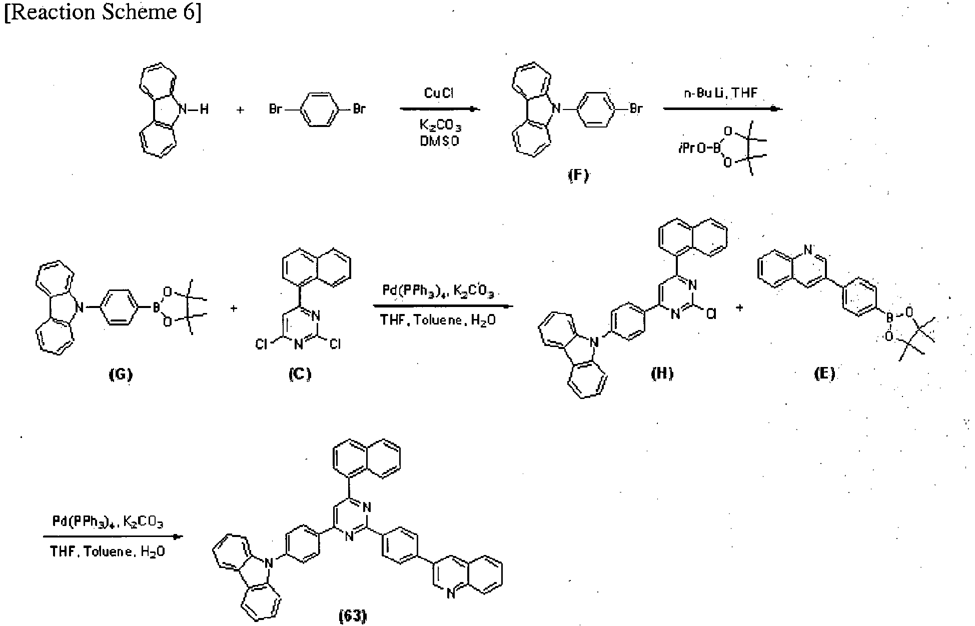

### First Step: Synthesizing Intermediate Product (F)

50.8 g (304 mmol) of carbazole, 71.6 g (304 mmol) of 1,4-dibromobenzene, 3.76 g (38 mmol) of cuprous chloride, and 83.9 g (607 mmol) of potassium carbonate were suspended in 322 ml of dimethyl sulfoxide and refluxed for 8 hours under nitrogen atmosphere while heating. The obtained reaction fluid was cooled to room temperature, and recrystallized using methanol.

The obtained crystal was separated by filtration, and the resulting product was purified using a silica gel column chromatography to obtain 55.9 g (61.3%) of intermediate product (F).

### Second Step: Synthesizing Intermediate Product (G)

37.8 g (117 mmol) of the intermediate product (F) was dissolved in 378 ml of tetrahydrofuran, 100.5 ml (161mmol) of 1.6M n-butyl lithium hexane solution was added at -70 °C under argon atmoshhere, and then the resulting solution was agitated at -70 °C to -40 °C for 1 hour. The reaction fluid was cooled to -70 °C and 47.9 ml (235 mmol) of isopropyl tetramethyl dioxaboloane was added in a dropwise fashion. After the resulting solution was agitated at - 70 °C for 1 hour, the temperature increased to a room temperature and agiting was performed for 6 hours. 200 ml of water was added to the resulting solution and then agitated for 20 minutes.

After separating the reaction fluid into two layers, an organic layer was washed with a saturated sodium chloride aqueous solution and dried with anhydrous sodium sulfate.

The organic solvent was distillated and removed under reduced pressure, and then the residue was recrystallized with toluene. The obtained crystal was separated by filtration and washed with toluene to obtain 28.9 g (yield: 66.7 %) of intermediate product (G).

### Third Step: Synthesizing Intermediate Product (H)

26.8 g (73 mmol) of the intermediate product (G), 20.0 g (73 mmol) of the compound (C), and 2.1 g (1.8 mmol) of tetrakis-(triphenylphosphine)palladium were suspended in a mixed solvent of 600 ml of tetrahydrofuran and 400 ml of toluene to provide a suspension. The suspension was added to a solution in which 20.1 g (154 mmol) of potassium carbonate was dissolved in 400 ml of water. The obtained mixture was heated and refluxed for 8 hours. After separating the reaction fluid into two layers, an organic layer was washed with a saturated sodium chloride aqueous solution and dried with anhydrous sodium sulfate.

The organic solvent was distillated and removed under reduced pressure, and then the residue was recrystallized with toluene. The obtained crystal was separated by filtration and washed with toluene to obtain 23.0 g (yield: 65.4 %) of intermediate product (H).

### Fourth Step: Synthesizing Compound (63)

6.0 g (12 mmol) of the intermediate product (H), 4.5 g (14 mmol) of the compound (E), and 0.36 g (0.3 mmol) of tetrakis-(triphenylphosphine)palladium were suspended in a mixed solvent of 180 ml of tetrahydrofuran and 120 ml of toluene to provide a suspension. The suspension was added to a solution in which 3.4 g (25 mmol) of potassium carbonate was dissolved in 120 ml of water. The obtained mixture was heated and refluxed for 12 hours. After separating the reaction fluid into two layers, an organic layer was washed with a saturated sodium chloride aqueous solution and dried with anhydrous sodium sulfate.

The organic solvent was distillated and removed under reduced pressure, and then the residue was recrystallized with toluene. The obtained crystal was separated by filtration and washed with toluene to obtain 7.2 g (yield: 88.3 %) of compound (63).

¹H NMR(300MHz, CDCl₃) 9.31(s,1H), 8.92(d,2H), 8.62(d,2H), 8.45(m,2H), 8.19(d,3H), 7.71(m,20H); MS[M+1] 651.

The synthesized compounds were measured to determine glass transition temperature and thermal decomposition temperature by differential scanning calorimetry (DSC) and thermogravimetry (TGA).

### (Fabricating Organic Photoelectric Device)

### Example 1

A 15 Ω/cm² (1200 Å ITO glass substrate (Coming Inc.) was provided to have a size of 50 mm x 50 mm x 0.7 mm, and was cleaned in isopropyl alcohol and pure water for 5 minutes, respectively, and then washed with UV and ozone for 30 minutes.

N,N'-diphenyl-N,N'-bis-[4-(phenyl-m-tolylamino)-phenyl)]-biphenyl-4,4'-diamine (DNTPD) (40 nm), N,N'-di(1-naphthyl)-N,N'-diphenylbenzidine (NPB) (10 nm), EB-46 (fluorescent blue dopant, manufactured by E-Ray Optoelectronics Technology Co., Ltd): EB-512 (fluorescent blue host, manufactured by E-Ray Optoelectronics Technology Co., Ltd) 6 % (40 nm), and the compound (1) (10 nm) obtained from Synthesis Example 1 were sequentially thermal-evaporated on the surface of glass substrate to provide a hole injection layer (HIL), a hole transfer layer (HTL), an emission layer, and an electron transport layer (ETL).

As an electron injection layer (EIL), LiF was evaporated on the ETL to a thickness of 0.5 nm, and A1 was evaporated to a thickness of 100 nm to provide a LiF/Al electrode. The structure of the obtained organic photoelectric device is shown in FIG. 5.

### Example 2

An organic photoelectric device was fabricated in accordance with the same procedure as in Example 1, except that compound (2) (10 nm) obtained from Synthesis Example 2 was used instead of compound (1).

### Example 3

An organic photoelectric device was fabricated in accordance with the same procedure as in Example 1, except that compound (10) (10 nm) obtained from Synthesis Example 3 was used instead of compound (1).

### Example 4

An organic photoelectric device was fabricated in accordance with the same procedure as in Example 1, except that compound (11) (10 nm) obtained from Synthesis Example 4 was used instead of compound (1).

### Example 5

An organic photoelectric device was fabricated in accordance with the same procedure as in Example 1, except that compound (19) (10 nm) obtained from Synthesis Example 5 was used instead of compound (1).

### Example 6

An organic photoelectric device was fabricated in accordance with the same procedure as in Example 1, except that compound (63) (10 nm) obtained from Synthesis Example 6 was used instead of compound (1).

### Comparative Example 1

An organic photoelectric device was fabricated in accordance with the same procedure as in Example 1, except that the compound of Alq₃ (10 nm) represented by Chemical Formula 2 was used instead of compound (1).

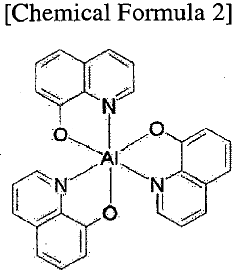

### Performance Measurement of the Organic Photoelectric Device

Each organic photoelectric device according to Examples 1 to 6 and Comparative Example 1 was measured regarding luminous efficiency according to a voltage. The measurement method is as follows.

### 1) Measurement of Current Density Change Depending on Voltage Change

The prepared organic photoelectric devices according to Examples 1 to 6 and Comparative Example 1 were increased in voltage from 0V to 14V and measured regarding a current value in a unit device by using a current-voltage device (Keithley 2400^{®}). Then, their current densities were measured by dividing the current value by area.

### 2) Measurement of Luminance Change Depending on Voltage Change

The organic photoelectric devices according to Examples 1 to 6 and Comparative Example 1 were increased in voltage from 0V to 14V and measured regarding luminance using a luminance meter (Minolta Cs-1000A).

### 3) Measurement of Electric Power Efficiency (Luminous Efficiency)

Electric power efficiency was calculated from the current density and the luminance measured from the "1) Measurement of current density change depending on voltage change"?and "2) Measurement of luminance change depending on voltage change," and voltage (V). The results are shown in the following Table 1.

**[Table 1]**

| | Initial voltage (Vₒₙ) | Luminance 1000 cd/m² | | Color coordinate CIE | |
|---|---|---|---|---|---|
| | | Driving voltage (V) | Electric power efficiency (1m/W) | x | y |
| Ex. 1 | 3.00 | 6.00 | 2.42 | 0.15 | 0.15 |
| Ex. 2 | 3.00 | 6.00 | 2.12 | 0.15 | 0.15 |
| Ex. 3 | 2.80 | 6.00 | 1.97 | 0.15 | 0.15 |
| Ex. 4 | 2.80 | 6.20 | 2.00 | 0.15 | 0.15 |
| Ex. 5 | 3.22 | 7.04 | 2.01 | 0.15 | 0.15 |
| Ex. 6 | 3.03 | 6.86 | 2.05 | 0.15 | 0.15 |
| Comp. Ex. 1 | 3.80 | 8.20 | 1.87 | 0.15 | 0.15 |

Referring to Table 1, it is confirmed that the organic photoelectric devices according to Examples 1 to 6 in which the electron transport layer was formed with the material for an organic photoelectric device according to the present invention had excellent electric power efficiency (Lm/W) performance together with a low driving voltage, compared to the case of using the electron transport layer of Alq₃ according to Comparative Example 1. Accordingly, the organic compound according to one embodiment of the present invention had high thermal stability, a low driving voltage, and high luminous efficiency as shown in the performance result of the organic photoelectric device, so it is anticipated that it can improve the life-span of an organic photoelectric device. It is considered that the asymmetry of the material for an organic photoelectric device enriched the amorphous characteristic, so it suppressed the crystallization resulting in improved life-span of the device.

### 4) Measurement of Thermal Characteristic

A first analysis was carried out with the compounds obtained from Synthesis Examples 1 to 6 by differential scanning calorimetry (DSC), and then a second analysis was carried out with the compounds, thereby completing the first analysis.

The compound according to Synthesis Example 1 showed a melting point peak in the first analysis, but it did not show a melting point peak in the second analysis. From the results, it is confirmed that the compound according to Synthesis Example 1 was present in the stable asymmetric state.

In addition, it is confirmed that the compounds according to Synthesis Examples 2 to 6 were present in the amorphous state in accordance with the same method. Accordingly, it is anticipated that the organic light emitting diode including each compound according to Synthesis Examples 1 to 6 was not affected by Joule heat during the driving, and the life-span characteristic was more improved compared to the conventional organic photoelectric device.

## Claims

1. A material for an organic photoelectric device comprising an asymmetric compound represented by the following Chemical Formula 1: 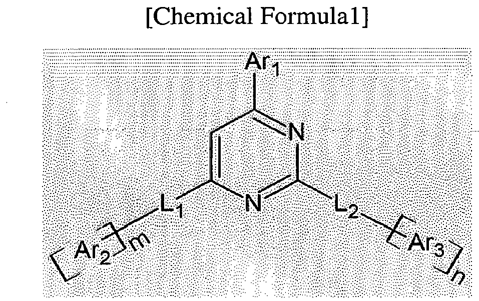 wherein, in the above Chemical Formula 1,
Ar₂ and Ar₃ are independently selected from the group consisting of a substituted or unsubstituted carbazolyl, a substituted or unsubstituted C2 to C30 heteroaryl, a substituted or unsubstituted C2 to C30 arylamine, and a substituted or unsubstituted C2 to C30 heteroarylamine,
L₁ and L₂ are independently selected from the group consisting of a substituted or unsubstituted phenylene, a substituted or unsubstituted naphthylene, and a substituted or unsubstituted anthracene, and
m and n are integers ranging from 1 to 4, **characterised in that** Ar₁ is selected from the group consisting of hydrogen, an unsubstituted phenyl, an unsubstituted naphthyl, an unsubstituted anthracenyl, an unsubstituted phenanthrenyl, an unsubstituted pyrenyl, an unsubstituted perylenyl, and an unsubstituted chrysenyl.

2. The material of claims 1, wherein Ar₂ and Ar₃ are independently selected from the group consisting of imidazolyl, thiazolyl, oxazolyl, oxadiazolyl, triazolyl, pyridinyl, pyridazine, quinolinyl, isoquinolinyl, acridyl, imidazopyridinyl, imidazopyrimidinyl, diphenyl amine, dinaphthyl amine, dibiphenyl amine, phenyl naphthyl amine, phenyl diphenyl amine, ditolyl amine, phenyl tolyl amine, carbazoyl, triphenylamine, and dipyridylamine.

3. The material of claims 1 to 2, wherein L₁ and L₂ are phenylene.

4. The material of claims 1 to 3, wherein the compound represented by the above Chemical Formula 1 comprises the following compounds (1) to (90), or combinations thereof:

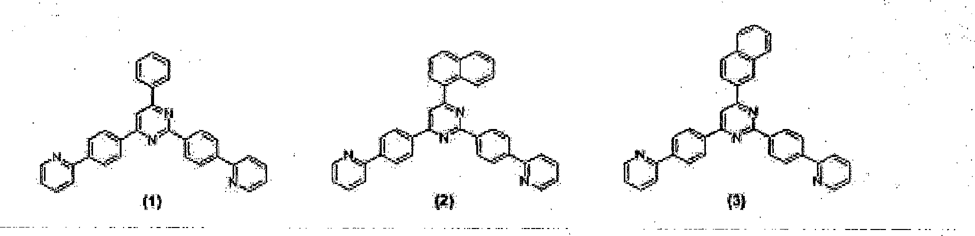

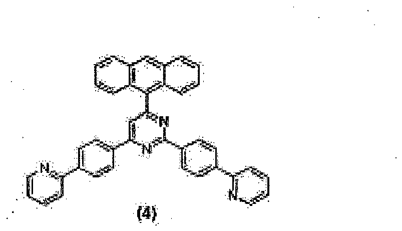

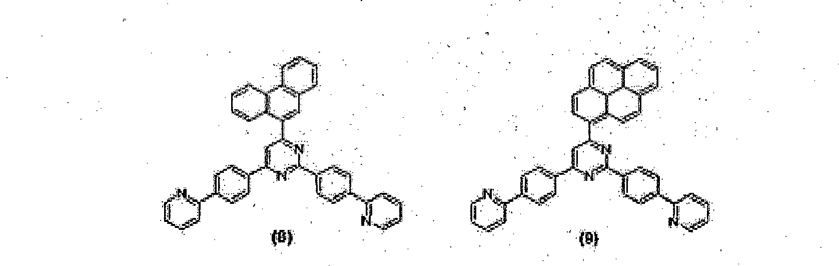

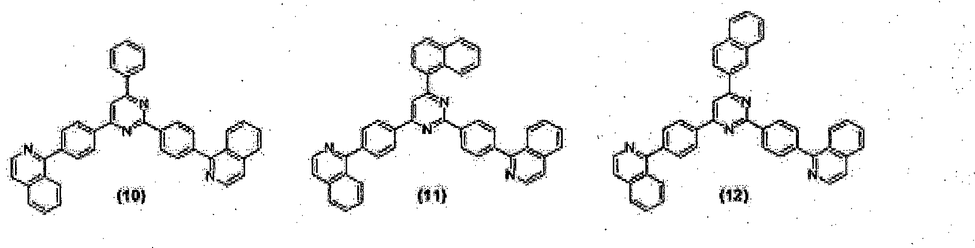

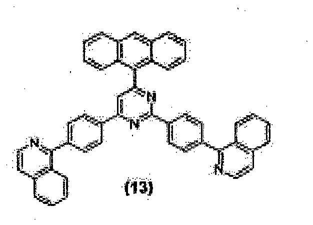

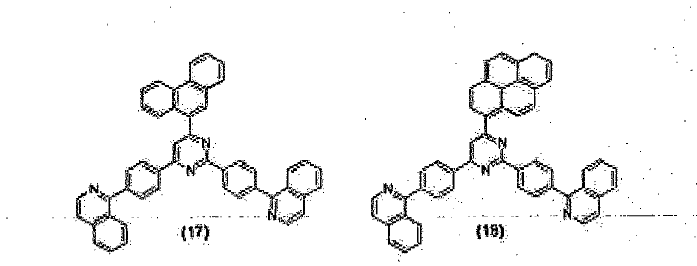

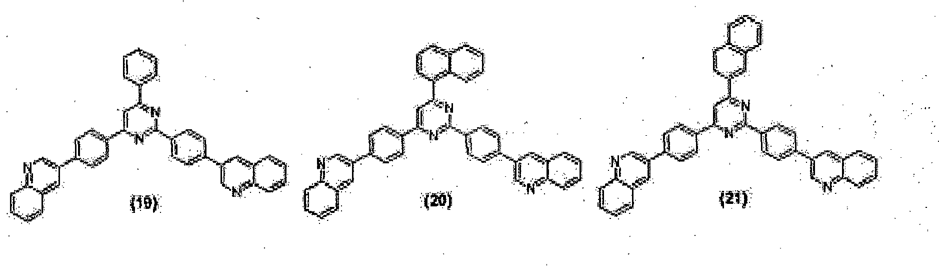

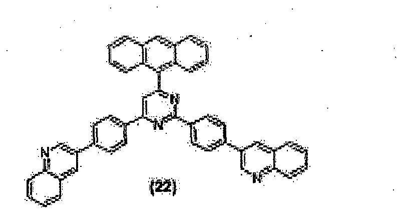

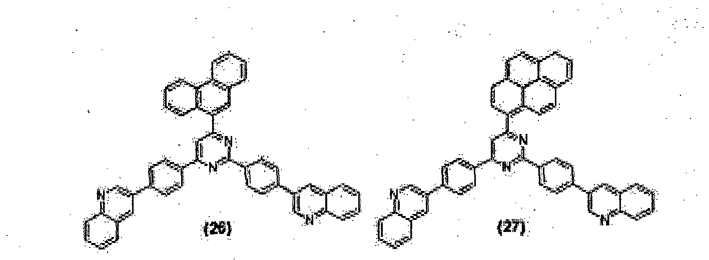

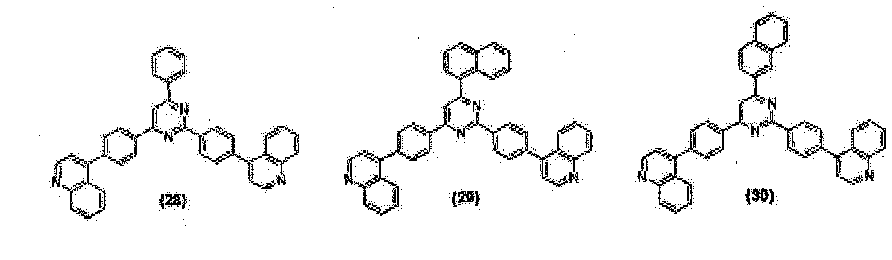

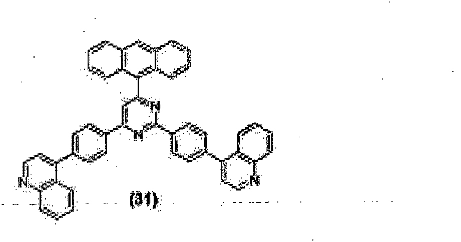

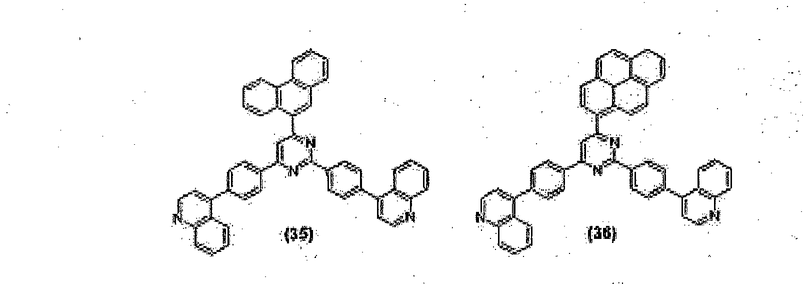

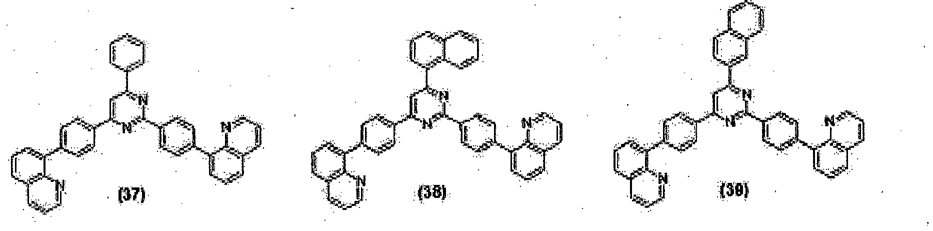

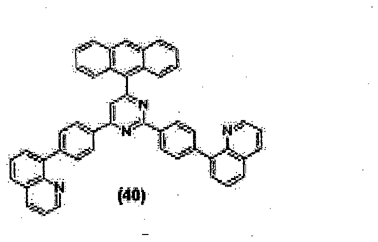

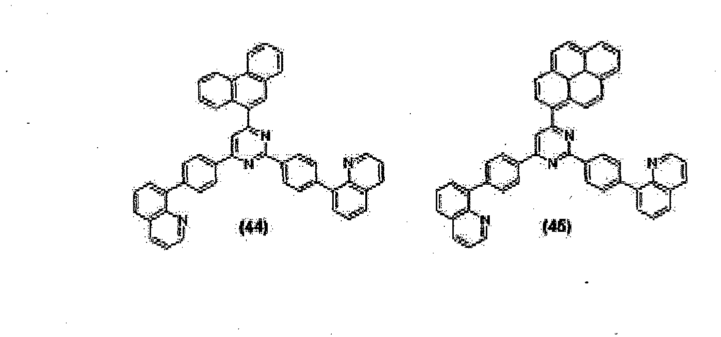

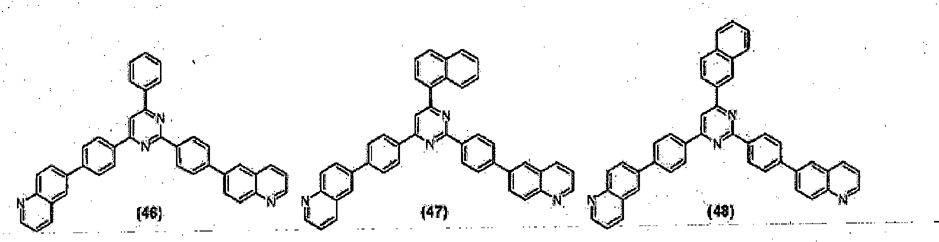

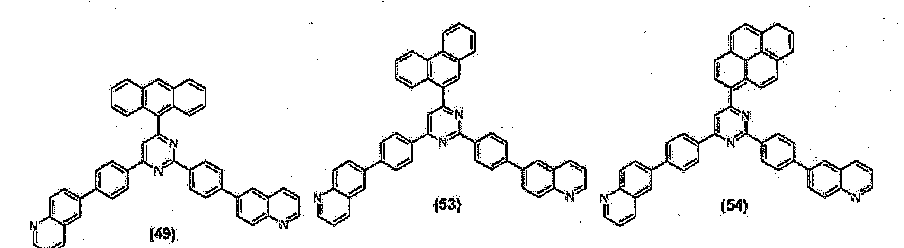

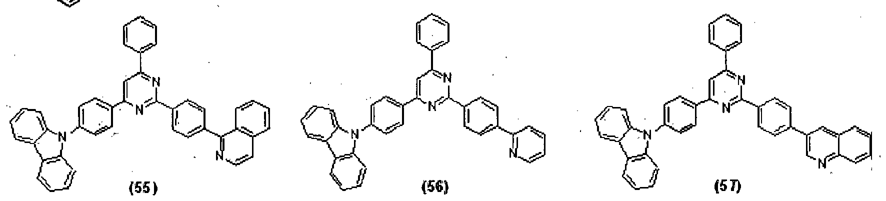

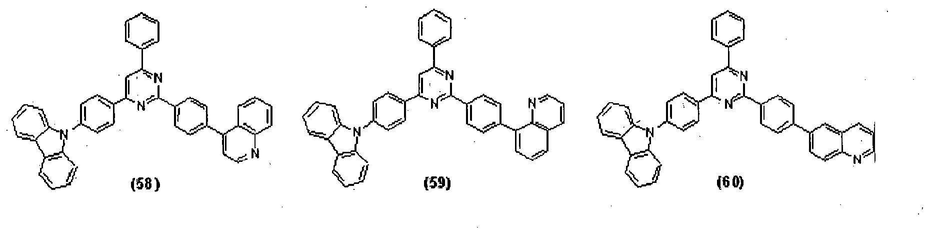

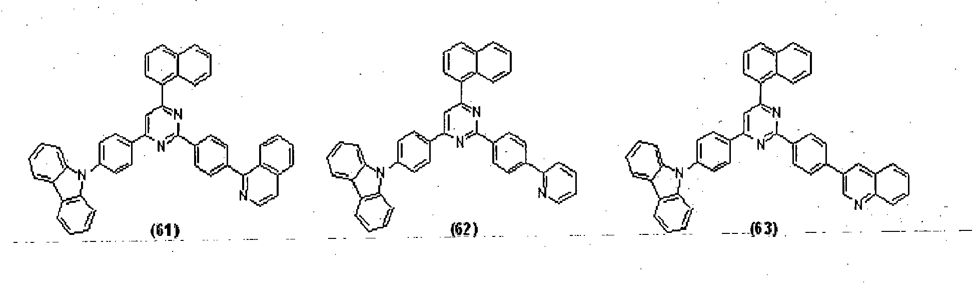

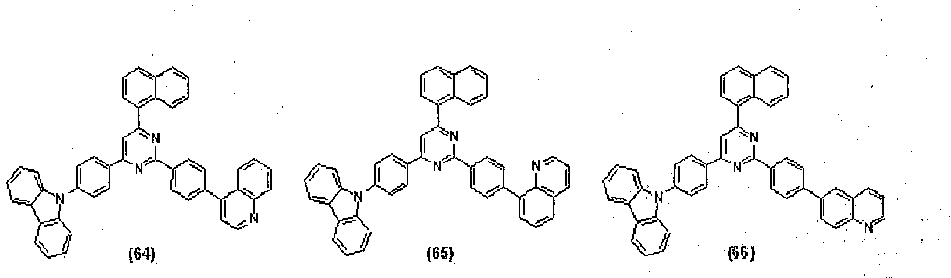

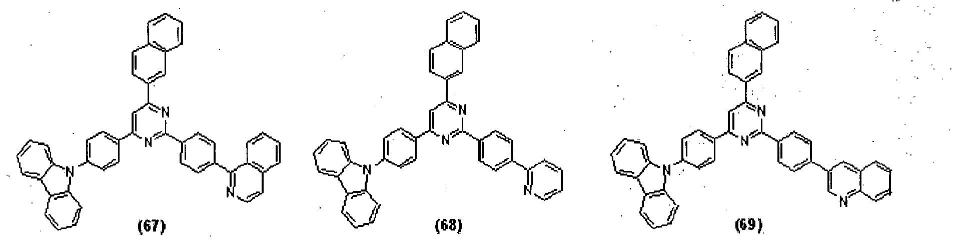

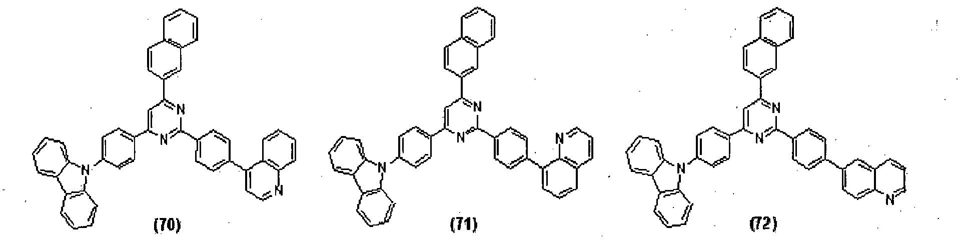

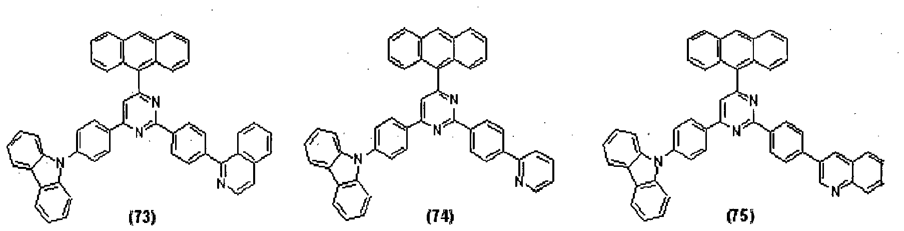

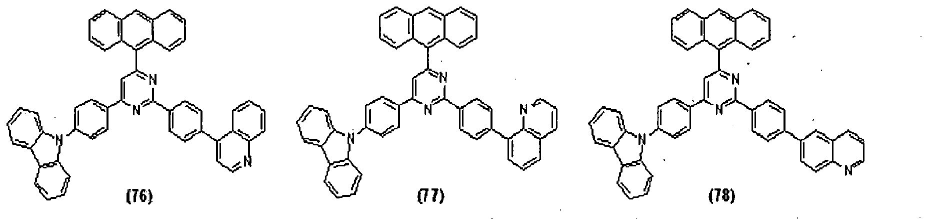

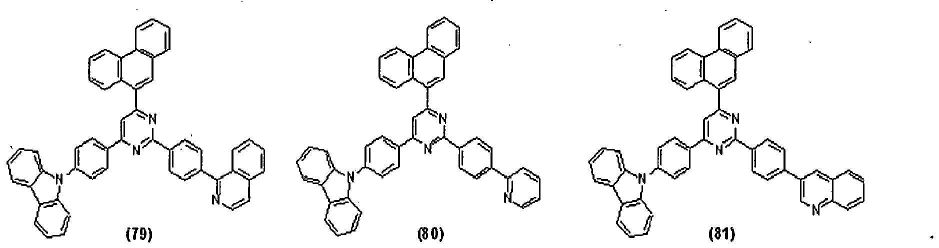

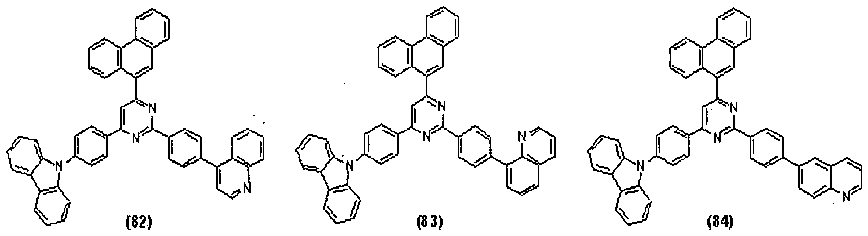

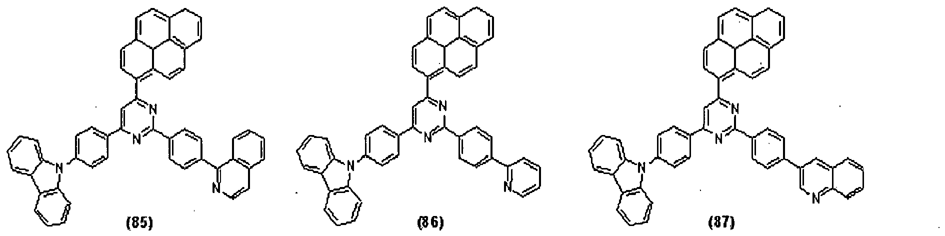

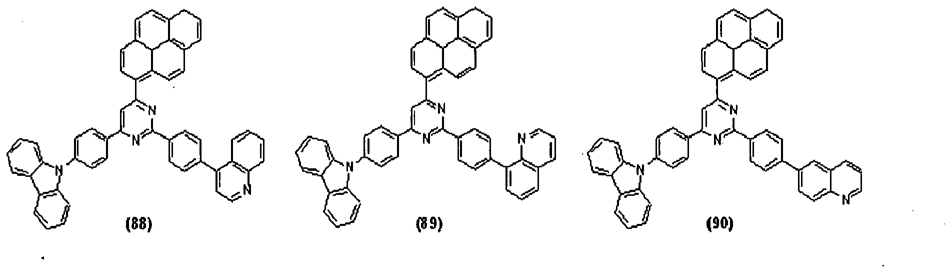

5. An organic photoelectric device comprising an anode, a cathode, and at least one organic thin layer interposed between the anode and cathode,
wherein at least one of the organic thin layer comprises the material for an organic photoelectric device according to one of claims 1 to 4.

6. The organic photoelectric device of claim 5, wherein the at least one organic thin layer comprises an emission layer; and at least one layer selected from the group consisting of a hole transport layer (HTL), a hole injection layer (HIL), an electron transport layer (ETL), an electron injection layer (EIL), a hole blocking layer, and combinations thereof.

7. The organic photoelectric device of claim 5, wherein the material for an organic photoelectric device is included in an electron transport layer (ETL) or an electron injection layer (EIL).

8. The organic photoelectric device of claim 5, wherein the material for an organic photoelectric device is included in an emission layer.

9. The organic photoelectric device of claim 5, wherein the material for an organic photoelectric device is included in an emission layer as a phosphorescent or fluorescent host.

10. The organic photoelectric device of claim 5, wherein the material for an organic photoelectric device is included in an emission layer as a fluorescent blue dopant.

11. The organic photoelectric device of claim 5, wherein the organic photoelectric device is selected from the group consisting of an organic light emitting diode, an organic solar cell, an organic transistor, an organic photo-conductor drum, and an organic memory device.

12. A display device comprising the organic photoelectric device according to claim 5 to 11.

## Patentansprüche

1. Material für eine organische photoelektrische Vorrichtung, umfassend eine asymmetrische Verbindung der folgenden Chemischen Formel 1: 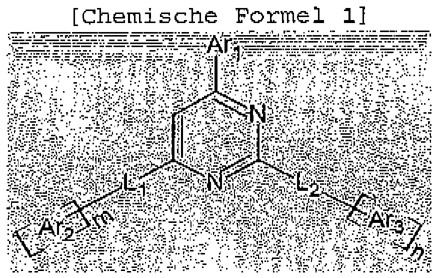 wobei in der obigen Chemischen Formel 1
Ar₂ und Ar₃ unabhängig aus der Gruppe bestehend aus einem substituierten oder unsubstituierten Carbazolyl, einem substituierten oder unsubstituierten C2- bis C30-Heteroaryl, einem substituierten oder unsubstituierten C2- bis C30-Arylamin und einem substituierten oder unsubstituierten C2- bis C30-Heteroarylamin ausgewählt sind,
L₁ und L₂ unabhängig aus der Gruppe bestehend aus einem substituierten oder unsubstituierten Phenylen, einem substituierten oder unsubstituierten Naphthylen und einem substituierten oder unsubstituierten Anthracen ausgewählt sind und
m und n für ganze Zahlen im Bereich von 1 bis 4 stehen,
**dadurch gekennzeichnet, dass**
Ar₁ aus der Gruppe bestehend aus Wasserstoff, einem unsubstituierten phenyl, einem unsubstituierten Naphthyl, einen unsubstituierten Anthracenyl, einem unsubstituierten Phenanthrenyl, einem unsubstituierten Pyrenyl, einem unsubstituierten Perylenyl und einem unsubstituierten Chrysenyl ausgewählt ist.

2. Material nach Anspruch 1, wobei Ar₂ und Ar₃ unabhängig aus der Gruppe bestehend aus Imidazolyl, Thiazolyl, Oxazolyl, Oxadiazolyl, Triazolyl, Pyridinyl, Pyridazin, Chinolinyl, Isochinolinyl, Acridyl, Imidazopyridinyl, Imidazopyrimidinyl, Diphenylamin, Dinaphthylamin, Dibiphenylamin, Phenylnaphthylamin, Phenyldiphenylamin, Ditolylamin, Phenyltolylamin, Carbazolyl, Triphenylamin und Dipyridylamin ausgewählt sind.

3. Material nach den Ansprüchen 1 bis 2, wobei L₁ und L₂ für Phenylen stehen.

4. Material nach den Ansprüchen 1 bis 3, wobei die durch die obige Chemische Formel 1 wiedergegebene Verbindung die folgenden Verbindungen (1) bis (90) oder Kombinationen davon umfasst:

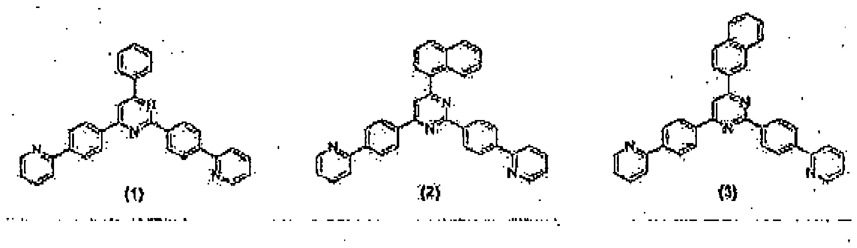

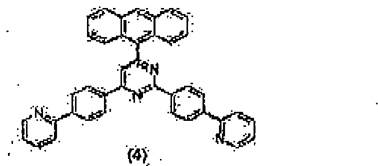

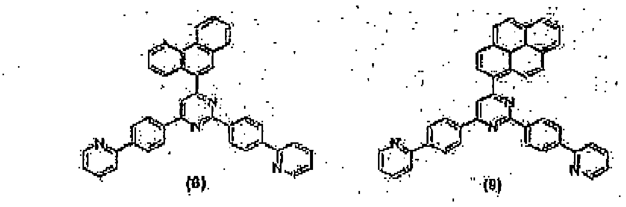

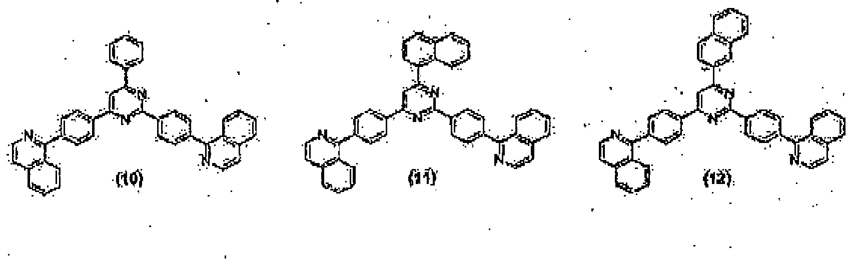

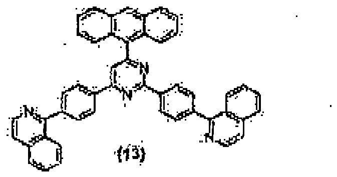

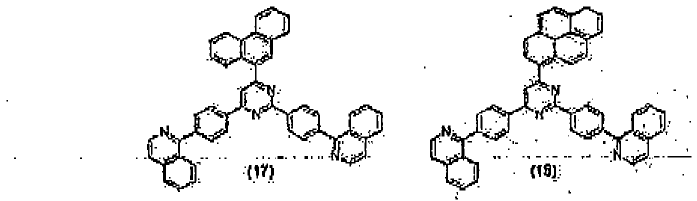

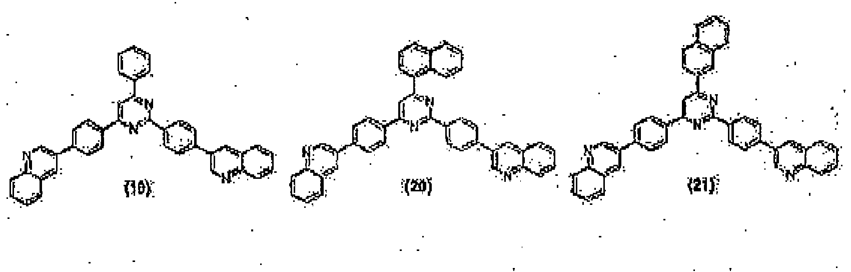

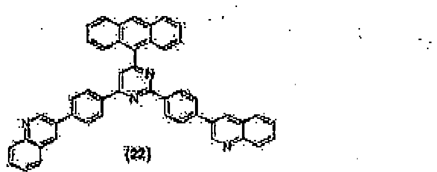

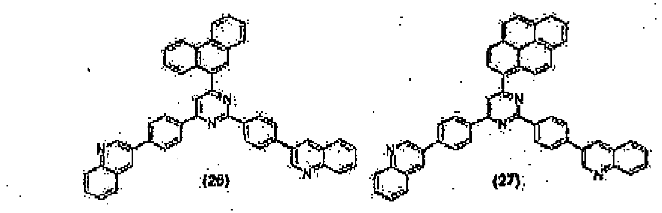

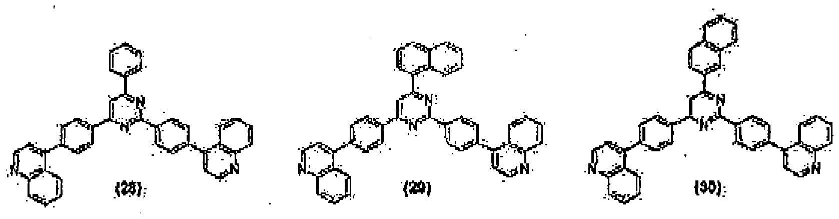

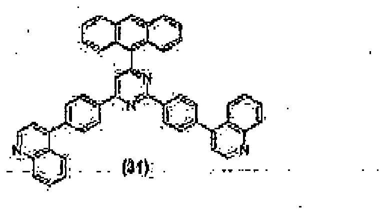

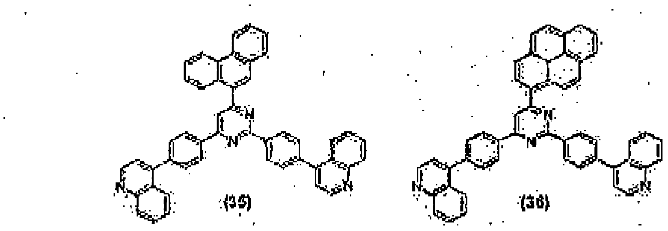

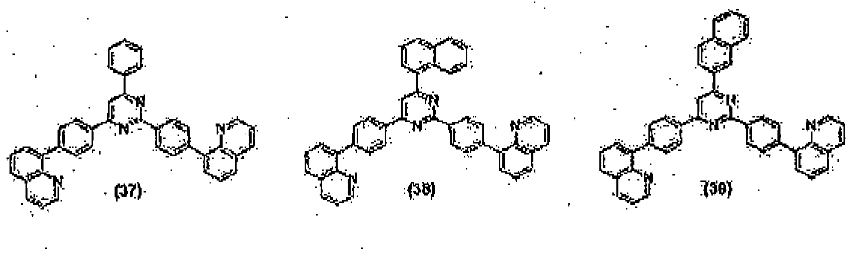

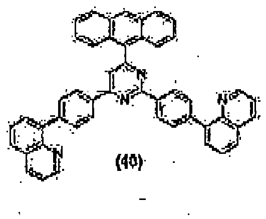

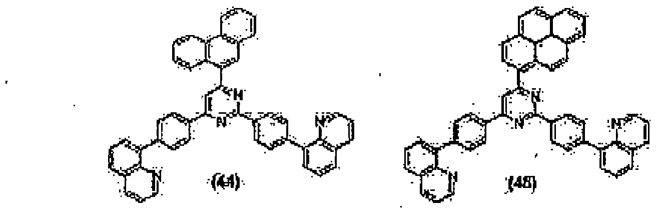

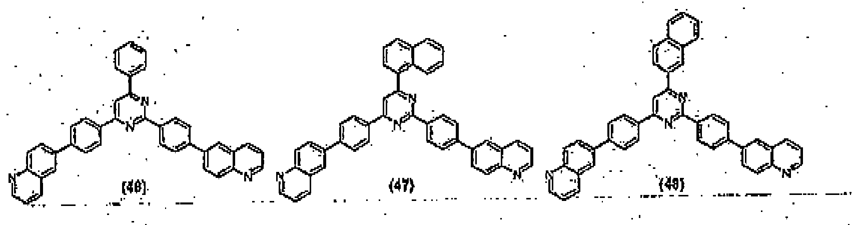

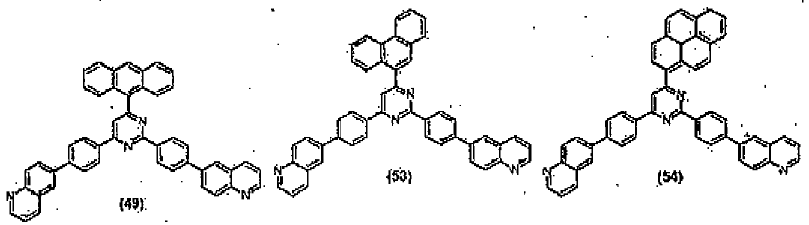

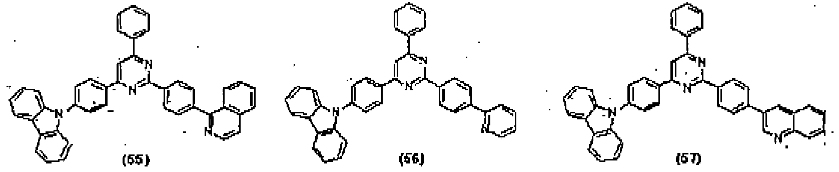

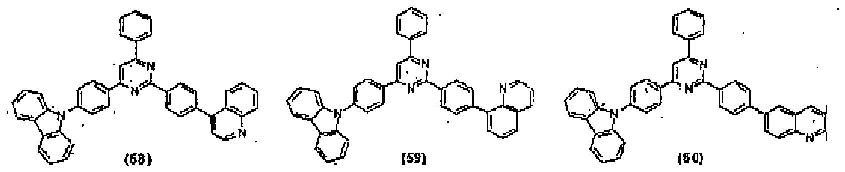

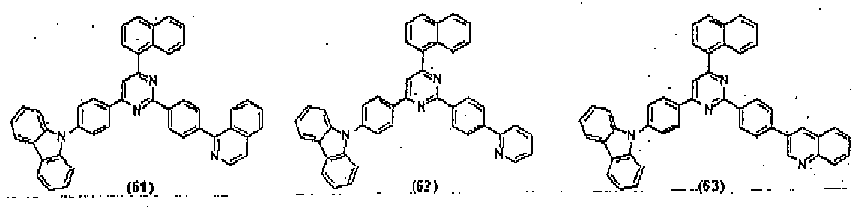

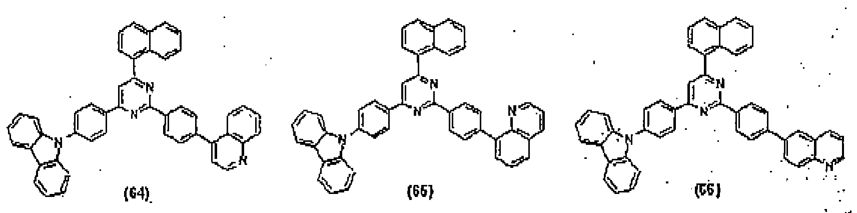

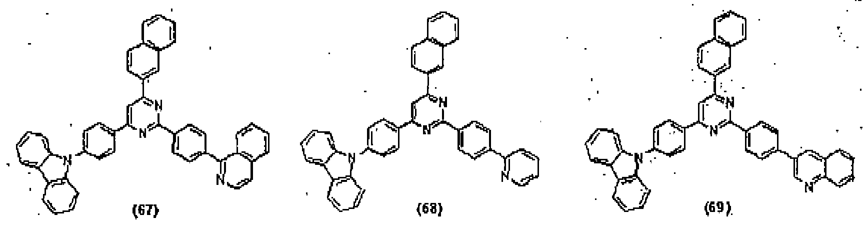

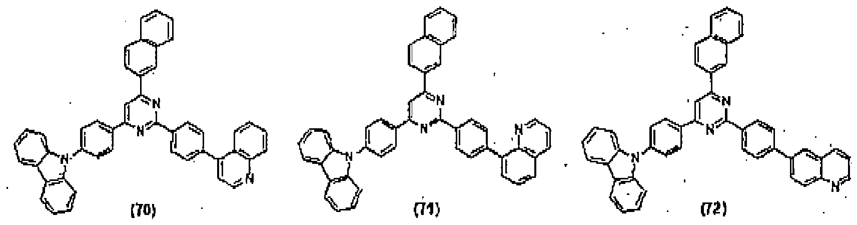

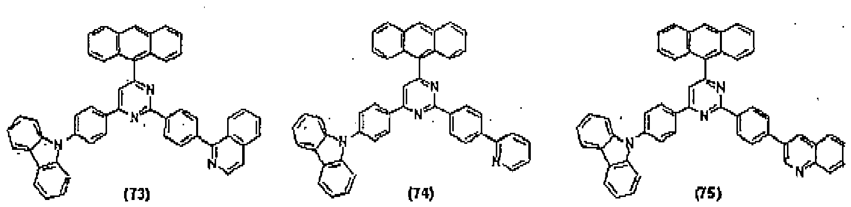

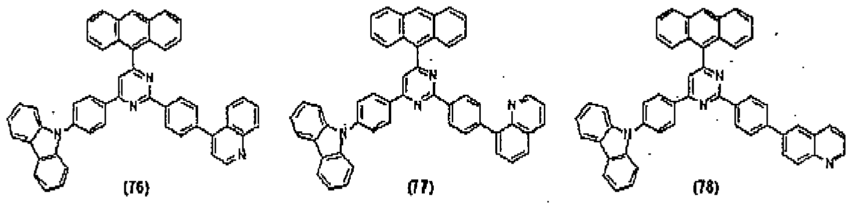

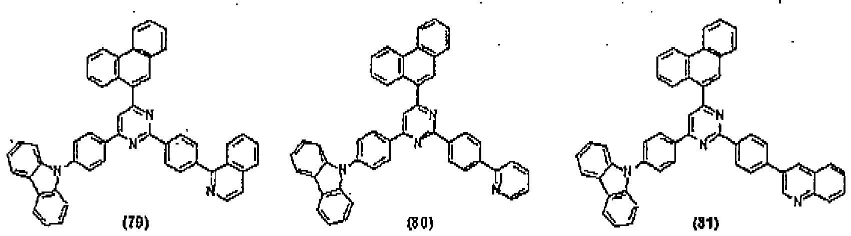

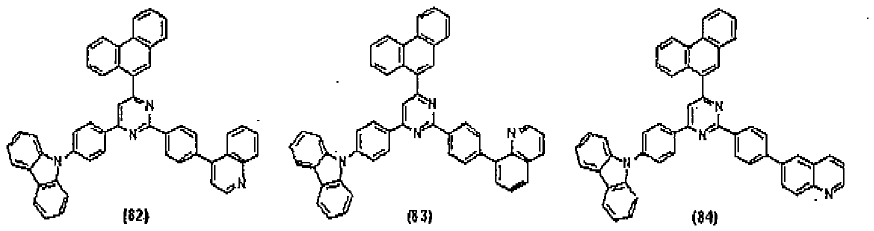

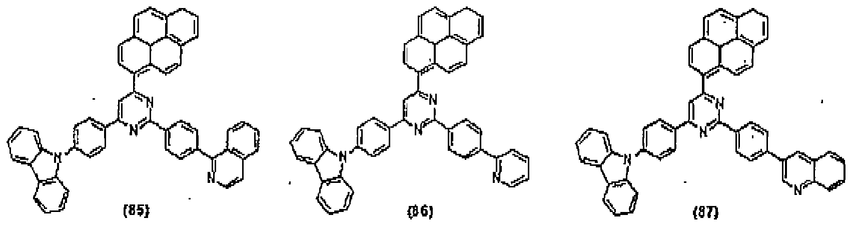

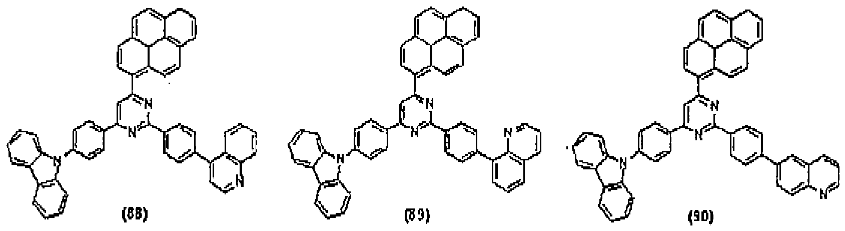

5. Organische photoelektrische Vorrichtung, umfassend eine Anode, eine Kathode und mindestens eine organische dünne Schicht zwischen der Anode und Kathode,
wobei mindestens eine der organischen dünnen Schichten das Material für eine organische photoelektrische Vorrichtung nach einem der Ansprüche 1 bis 4 umfasst.

6. Organische photoelektrische Vorrichtung nach Anspruch 5, wobei die mindestens eine organische dünne Schicht eine Emissionsschicht und mindestens eine Schicht aus der Gruppe bestehend aus einer Lochtransportschicht (Hole Transport Layer, HTL), einer Lochinjektionsschicht (Hole Injection Layer, HIL), einer Elektronentransportschicht (Electron Transport Layer, ETL), einer Elektroneninjektionsschicht (Electron Injection Layer, EIL), einer Lochblockierschicht und
Kombinationen davon umfasst.

7. Organische photoelektrische Vorrichtung nach Anspruch 5, wobei das Material für eine organische photoelektrische Schicht in einer Elektronentransportschicht (ETL) oder einer Elektroneninjektionsschicht (EIL) enthalten ist.

8. Organische photoelektrische Vorrichtung nach Anspruch 5, wobei das Material für eine organische photoelektrische Schicht in einer Emissionsschicht enthalten ist.

9. Organische photoelektrische Vorrichtung nach Anspruch 5, wobei das Material für eine organische photoelektrische Schicht als phosphoreszierender oder fluoreszierender Wirt in einer Emissionsschicht enthalten ist.

10. Organische photoelektrische Vorrichtung nach Anspruch 5, wobei das Material für eine organische photoelektrische Schicht als fluoreszierender blauer Dotierstoff in einer Emissionsschicht enthalten ist.

11. Organische photoelektrische Vorrichtung nach Anspruch 5, wobei die organische photoelektrische Vorrichtung aus der Gruppe bestehend aus einer organischen Leuchtdiode, einer organischen Solarzelle, einem organischen Transistor, einer organischen Photoleitertrommel und einer organischen Speichervorrichtung ausgewählt ist.

12. Anzeigevorrichtung, umfassend eine organische photoelektrische Vorrichtung nach Anspruch 5 bis 11.

## Revendications

1. Matériau pour un dispositif photoélectrique organique comprenant un composé asymétrique représenté par la formule chimique 1 suivante : 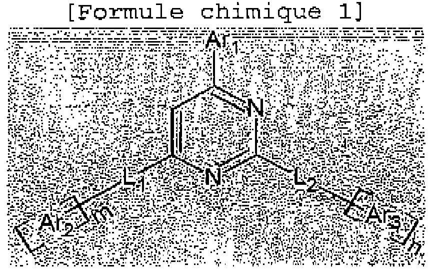 dans lequel, dans la formule chimique 1 ci-dessus,
Ar₂ et Ar₃ sont indépendamment choisis dans le groupe constitué par un carbazolyl, substitué ou non substitué, un hétéroaryle en C2 à C30 substitué ou non substitué, une arylamine en C2 à C30 substituée ou non substituée, et une hétéroarylamine en C2 à C30 substituée ou non substituée,
L₁ et L₂ sont indépendamment choisis dans le groupe constitué par un phénylène substitué ou non substitué, un naphtylène substitué ou non substitué, et un anthracène substitué ou non substitué, et
m et n sont des entiers allant de 1 à 4, **caractérisé en ce que**
Ar₁ est choisi dans le groupe constitué par l'hydrogène, un phényle non substitué, un naphtyle non substitué, un anthracényle non substitué, un phénanthrényle non substitué, un pyrényle non substitué, un pérylényle non substitué, et un chrysényle non substitué.

2. Matériau selon la revendication 1, dans lequel Ar₂ et Ar₃ sont indépendamment choisis dans le groupe constitué par les radicaux imidazolyle, thiazolyle, oxazolyle, oxadiazalyla, triazolyle, pyridinyle, pyridazine, quinolinyle, isoquinolinyle, acridyle, imidazopyridinyle, imidazopyrimidinyle, diphénylamine, dinaphtylamine, dibiphénylamine, phénylnaphtylamine, phényldiphénylamine, ditolylamine, phényltolylamine, carbazoyle, triphénylamine, et dipyridylamine.

3. Matériau selon les revendications 1 à 2, dans lequel L₁ et L₂ sont des phénylènes.

4. Matériau selon les revendications 1 à 3, dans lequel le composé représenté par la formule chimique 1 ci-dessus comprend les composés (1) à (90) suivants, ou des combinaisons de ceux-ci :

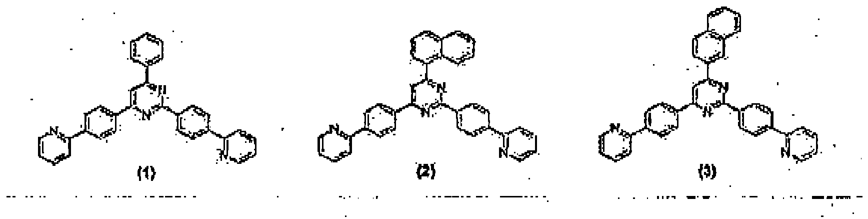

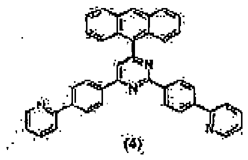

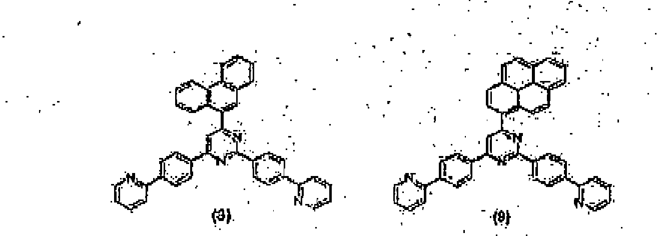

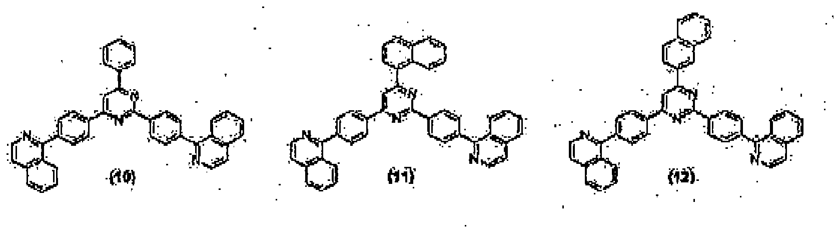

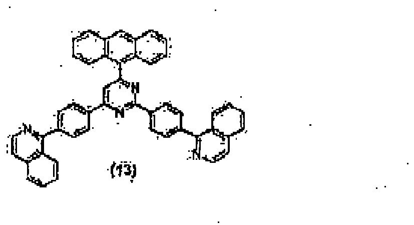

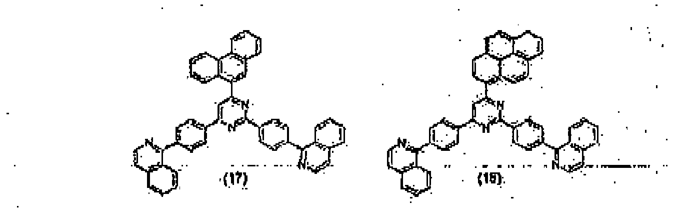

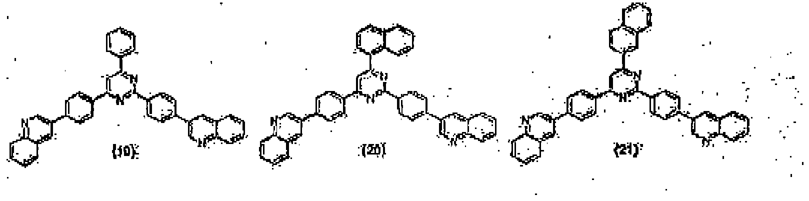

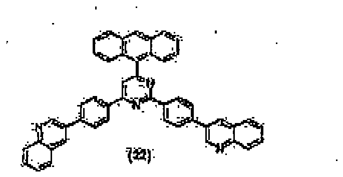

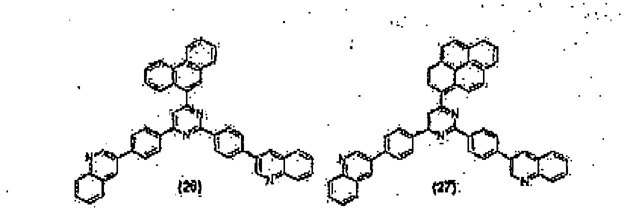

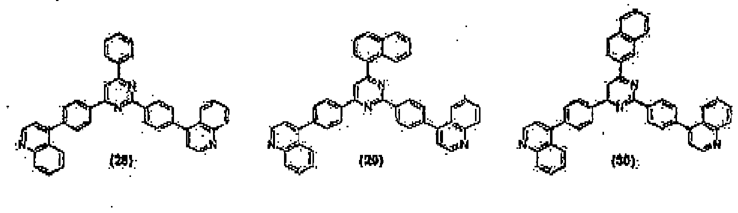

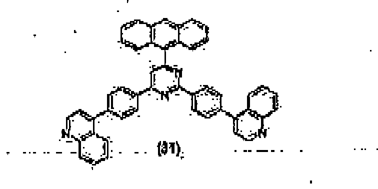

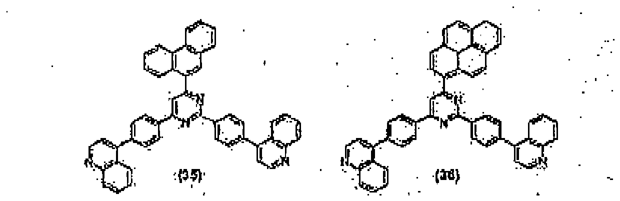

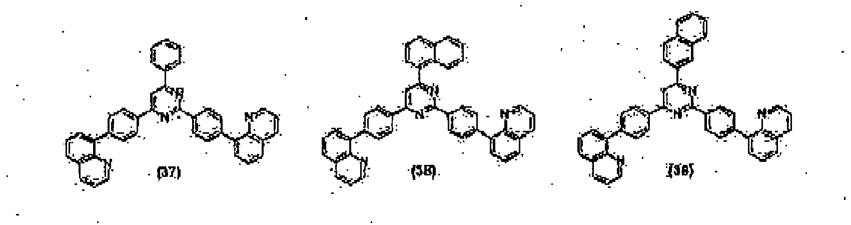

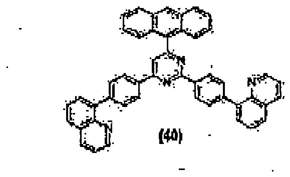

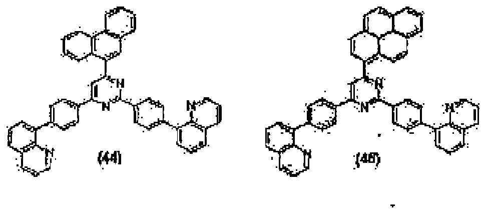

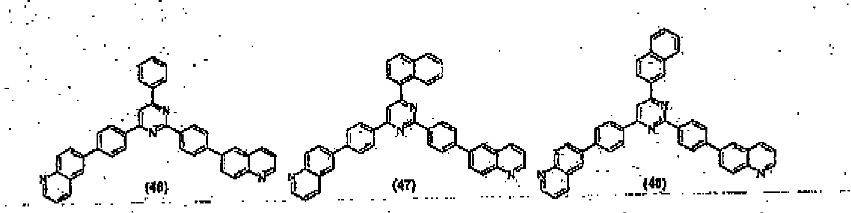

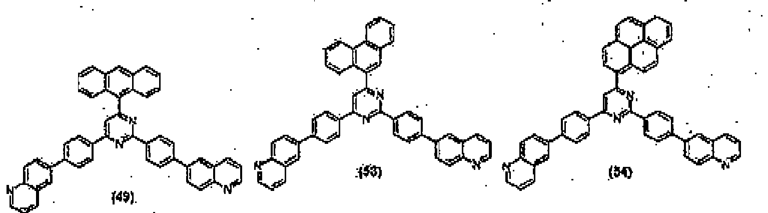

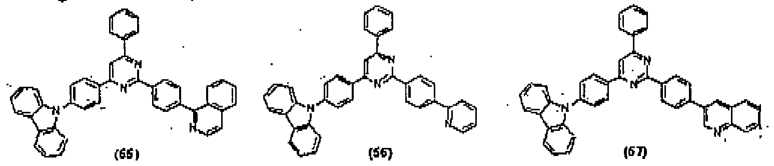

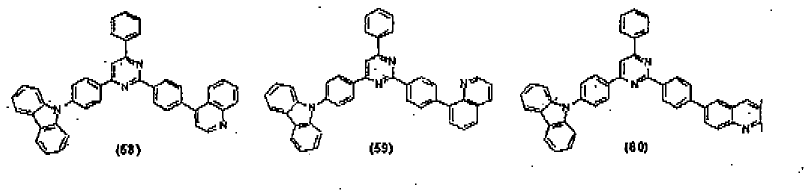

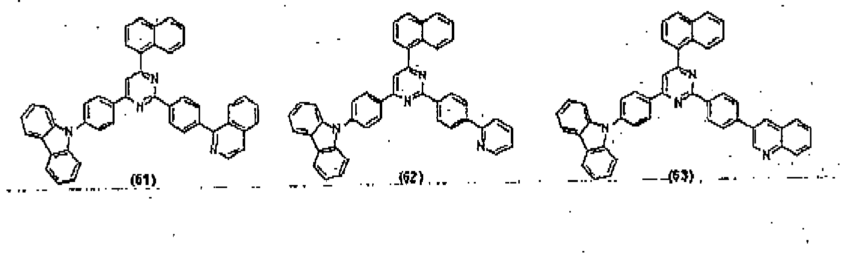

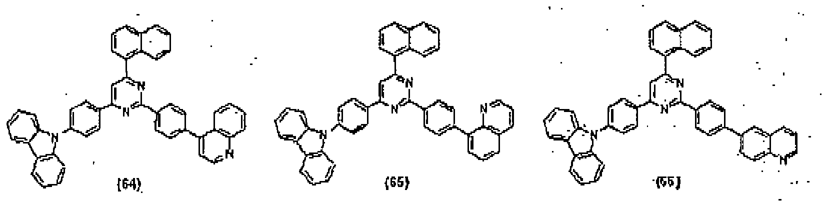

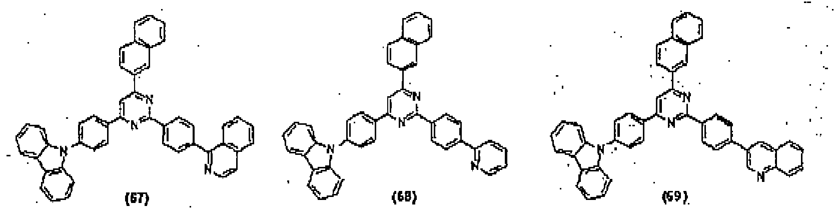

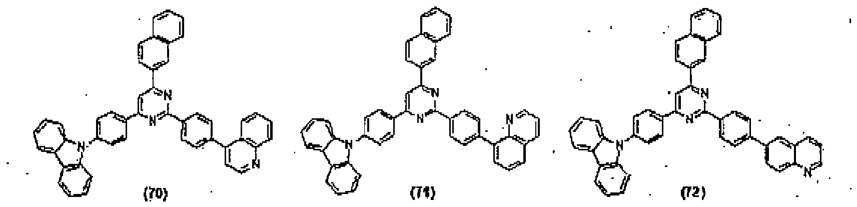

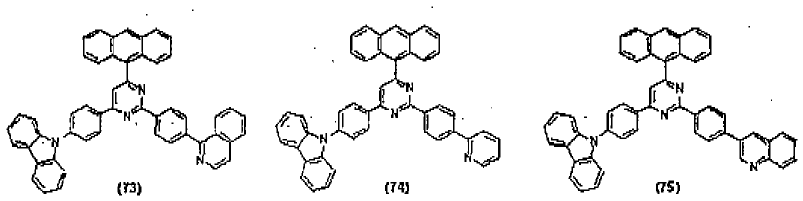

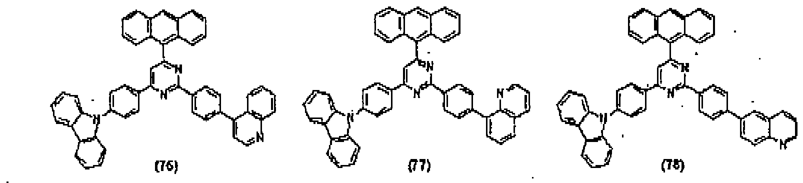

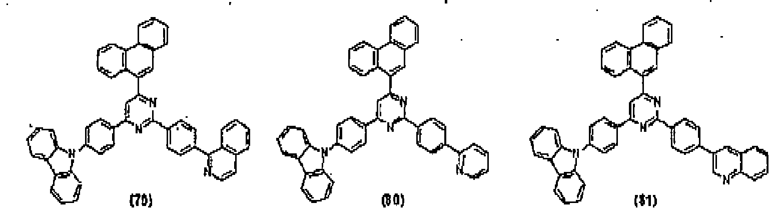

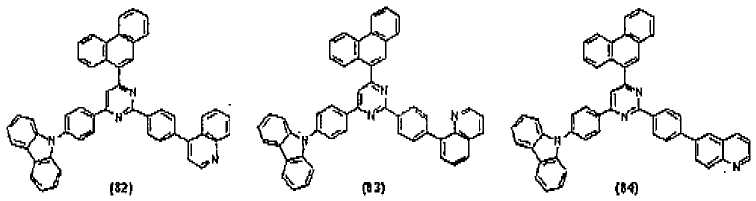

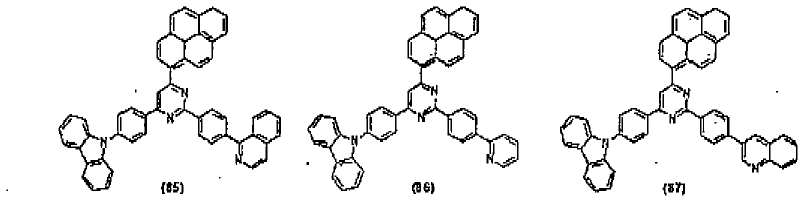

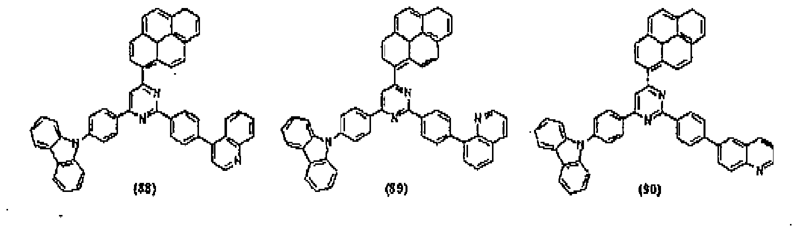

5. Dispositif photoélectrique organique comprenant une anode, une cathode, et au moins une couche mince organique intercalée entre l'anode et la cathode,
dans lequel au moins une des couches minces organiques comprend le matériau pour un dispositif photoélectrique organique selon une des revendications 1 à 4.

6. Dispositif photoélectrique organique selon la revendication 5, dans lequel l'au moins une couche mince organique comprend une couche d'émission ; et au moins une couche choisie dans le groupe constitué par une couche de transport de trous (HTL), 1 une couche d'injection de trous (HIL), une couche de transport d'électrons (ETL), une couche d'injection d'électron (EIL), 1 une couche de blocage de trous, et les combinaisons de celles-ci.

7. Dispositif photoélectrique organique selon la revendication 5, le matériau pour un dispositif photoélectrique organique étant contenu dans une couche de transport d'électrons (ETL) ou une couche d'injection d'électrons (EIL).

8. Dispositif photoélectrique organique selon la revendication 5, le matériau pour un dispositif photoélectrique organique étant contenu dans une couche d'émission.

9. Dispositif photoélectrique organique selon la revendication 5, le matériau pour un dispositif photoélectrique organique étant contenu dans une couche d'émission en tant qu'hôte phosphorescent ou fluorescent.

10. Dispositif photoélectrique organique selon la revendication 5, le matériau pour un dispositif photoélectrique organique étant contenu dans une couche d'émission en tant que dopant fluorescent bleu.

11. Dispositif photoélectrique organique selon la revendication 5, le dispositif photoélectrique organique étant choisi dans le groupe constitué par une diode électroluminescente organique, 1 une cellule solaire organique, un transistor organique, un tambour photoconducteur organique, et un dispositif de mémoire organique.

12. Dispositif d'affichage comprenant le dispositif photoélectrique organique selon les revendications 5 à 11.
